# EUROPEAN PATENT APPLICATION

(11) **EP 4 425 547 A1**
(43) Date of publication of application: **04.09.2024**
(21) Application number: 22886470.8
(22) Date of filing: 08.09.2022
(51) Int. Cl.: H01L 25/065, H01L 21/3205, H01L 21/768, H01L 21/822, H01L 23/522, H01L 25/07, H01L 25/18, H01L 27/04, H01L 27/146

(54) **SEMICONDUCTOR DEVICE, APPARATUS, AND METHOD FOR MANUFACTURING SEMICONDUCTOR DEVICE**

(30) Priority: 26.10.2021 JP 2021174605
(71) Applicant: Sony Semiconductor Solutions Corporation, Atsugi-shi, Kanagawa 243-0014 (JP)
(72) Inventor: SHIGETOSHI, Takushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/033661
(87) International publication number: WO 2023/074136

(57) **Abstract**

A semiconductor device capable of improving integration of elements within a second element chip is provided.

A semiconductor device according to the present technology includes at least one first element chip, and at least one chip laminated with the first element chip and smaller than the first element chip. The at least one chip includes at least one second element chip. The first element chip has a laminated structure where a first semiconductor substrate and a first wiring layer are laminated. The second element chip has a laminated structure where a second semiconductor substrate and a second wiring layer are laminated. The first wiring layer and the second wiring layer are joined face-to-face with each other. The semiconductor device further includes an external connection terminal disposed at a position farther from the first element chip in a lamination direction than a rear surface of the chip, the rear surface being a surface on the side opposite to the first element chip and a wire that has at least a part disposed around the chip and electrically connects the first wiring layer and the external connection terminal.

## Description

### [Technical Field]

A technology according to the present disclosure (hereinafter also referred to as the "present technology") relates to a semiconductor device, an apparatus, and a manufacturing method of the semiconductor device.

### [Background Art]

A semiconductor device which includes a lamination of a first element chip and a second element chip smaller than the first element chip has hitherto been known (for example, see PTL 1). According to this type of semiconductor device, each of the first and second element chips is electrically connected to an external connection terminal disposed near the second element chip on the side opposite to the first element chip via a through electrode penetrating the first and second element chips.

### [Citation List]

### [Patent Literature]

[PTL 1]
US Patent No. 9,806,055

### [Summary]

### [Technical Problem]

According to the conventional semiconductor device, however, integration of elements provided within the second element chip lowers by the presence of the through electrode penetrating the second element chip.

Accordingly, a main object of the present technology is to provide a semiconductor device capable of improving integration of elements provided within a second element chip.

### [Solution to Problem]

The present technology provides a semiconductor device including at least one first element chip, and at least one chip laminated with the first element chip and smaller than the first element chip, in which the at least one chip includes at least one second element chip, the first element chip has a laminated structure where a first semiconductor substrate and a first wiring layer are laminated, the second element chip has a laminated structure where a second semiconductor substrate and a second wiring layer are laminated, the first wiring layer and the second wiring layer are joined face-to-face with each other, the semiconductor device further includes an external connection terminal disposed at a position farther from the first element chip in a lamination direction than a rear surface of the chip, the rear surface being a surface on the side opposite to the first element chip, and a wire that has at least a part disposed around the chip and electrically connects the first wiring layer and the external connection terminal.

The wire may have at least one vertical wire that extends in the lamination direction.

The wire may have at least one horizontal wire that extends in an in-plane direction and that is connected to the vertical wire.

The at least one vertical wire may include at least one first vertical wire that extends from the horizontal wire toward the first semiconductor substrate and at least one second vertical wire that extends from the horizontal wire toward the side opposite to the first semiconductor substrate.

The wire may be provided at least on a side surface of the chip via an insulation film.

The wire may be configured such that one end is electrically connected to the first wiring layer and that the other end is connected to the external connection terminal at a position farther from the first element chip in the lamination direction than the rear surface.

The semiconductor device may further include a filling film provided at least near a side surface of the chip in an area of the side surface and the rear surface of the chip.

The filling film may be flattened.

The filling film may be disposed near the rear surface and so provided as to cover a part of the external connection terminal.

The semiconductor device may further include an insulation layer that covers the filling film and a part of the external connection terminal and that exposes the remaining part of the external connection terminal.

The chip may be shaped to have a width that decreases with farness from the first element chip.

The chip may have a vertical cross section that has a substantially tapered shape whose width decreases with farness from the first element chip.

The chip may have a rounded corner.

The at least one chip may include at least one dummy chip.

The external connection terminal may have at least a part not overlapping with the chip in a planar view.

The insulation film may be provided only near the side surface, and a protection film that covers the rear surface of the chip may be further provided.

The semiconductor device may further include a different protection film that covers the protection film and a part of the external connection terminal and that exposes the remaining part of the external connection terminal.

The first element chip may be a pixel chip that includes a pixel region in the first semiconductor substrate.

The first element chip may include a transparent substrate joined to the first semiconductor substrate via an adhesive layer.

The semiconductor device may further include a support substrate joined to the chip via an insulation layer. The external connection terminal may be provided near the support substrate on the side opposite to the insulation layer. The wire may have a through electrode that penetrates the insulation layer and/or the support substrate.

The support substrate may have a size substantially identical to a size of the first element chip.

The insulation layer may be provided near the side surface and the rear surface of the chip. The wire may include a first through electrode that penetrates the insulation layer near the side surface of the chip, a second through electrode that penetrates the support substrate, and a horizontal wire that is disposed within the insulation layer and that electrically connects the first and second through electrodes.

The support substrate may be a semiconductor substrate.

The support substrate may include an element.

The insulation layer may be provided near the side surface and the rear surface of the chip, and the through electrode may penetrate the insulation layer near the side surface of the chip and the support substrate.

An etching stop layer may be provided at least on a portion included in the first wiring layer but not joined to the second wiring layer.

The first element chip may be a pixel chip that includes a pixel region in the first semiconductor substrate.

The first element chip may include a transparent substrate joined to the first semiconductor substrate via an adhesive layer.

The present technology further provides an apparatus including the semiconductor device.

The present technology further provides a first manufacturing method of a semiconductor device. The first manufacturing method includes a step of joining a first wiring layer of a first lamination stack that includes a first semiconductor substrate and the first wiring layer laminated together and a second wiring layer of at least one second lamination stack that is smaller than the first lamination stack and that includes a second semiconductor substrate and the second wiring layer laminated together, in such a manner that the first wiring layer and the second wiring layer face each other, a step of forming an insulation film from the second lamination stack on the side opposite to the first lamination stack, a step of etching the insulation film and the first wiring layer around the second lamination stack to expose an in-layer wire of the first wiring layer, and a step of forming a wire that is disposed at least near a side surface of the second lamination stack and that is connected to the in-layer wire.

The first manufacturing method may further include a step of forming a filling film from the second lamination stack on the side opposite to the first lamination stack, and a step of polishing and flattening at least the filling film.

The at least one second lamination stack may include a plurality of second lamination stacks having different thicknesses, and the step of flattening may also polish and flatten the plurality of second lamination stacks.

The first manufacturing method may further include a step of joining a support substrate to the filling film after the step of flattening.

In the first manufacturing method, the first lamination stack may constitute a pixel chip. The first manufacturing method may further include a step of forming at least any one of an anti-reflection film, a color filter, and an on-chip lens near the first semiconductor substrate on the side opposite to the first wiring layer after the step of joining the support substrate to the filling film.

The present technology further provides a second manufacturing method of a semiconductor device. The second manufacturing method includes a step of joining a first wiring layer of a first lamination stack that includes a first semiconductor substrate and the first wiring layer laminated together and a second wiring layer of a second lamination stack that is smaller than the first lamination stack and that includes a second semiconductor substrate and the second wiring layer laminated together, in such a manner that the first wiring layer and the second wiring layer face each other, a step of forming a filling film from the second lamination stack on the side opposite to the first lamination stack, a step of flattening the filling film, a step of etching the filling film and the first wiring layer around the second lamination stack to form a via that has one end connected to an in-layer wire of the first wiring layer, a step of forming a horizontal wire that is disposed on a surface of the filling film on the side opposite to the second lamination stack and that is electrically connected to the other end of the via, a step of covering the horizontal wire with a protection film, a step of arranging a support substrate near the protection film on the side opposite to the first lamination stack, and a step of forming a through electrode disposed on the support substrate and connected to the horizontal wire.

The support substrate may be a semiconductor substrate. The second manufacturing method may further include a step of forming a wiring layer on the protection film between the step of covering with the protection film and the step of arranging the support substrate.

In the second manufacturing step, the first lamination stack may constitute a pixel chip. The second manufacturing method may further include a step of forming at least any one of an anti-reflection film, a color filter, and an on-chip lens near the first semiconductor substrate on the side opposite to the first wiring layer after the step of joining the support substrate.

The present technology further provides a third manufacturing method of a semiconductor device. The third manufacturing method includes a step of joining a first wiring layer of a first lamination stack that includes a first semiconductor substrate and the first wiring layer laminated together and a second wiring layer of a second lamination stack that is smaller than the first lamination stack and that includes a second semiconductor substrate and the second wiring layer laminated together, in such a manner that the first wiring layer and the second wiring layer face each other, a step of forming an etching stop layer from the second lamination stack on the side opposite to the first lamination stack, a step of forming a filling film from the edging stop layer on the side opposite to the first lamination stack, a step that flattens the filling film, a step of joining a support substrate to the filling film, and a step of forming a through electrode that penetrates the support substrate, the filling film around the second lamination stack, and the etching stop layer.

In the third manufacturing method, the first lamination stack may constitute a pixel chip. The third manufacturing method may further include a step of forming at least any one of an anti-reflection film, a color filter, and an on-chip lens near the first semiconductor substrate on the side opposite to the first wiring layer after the step of joining the support substrate to the filling film.

### [Brief Description of Drawings]

[FIG. 1]

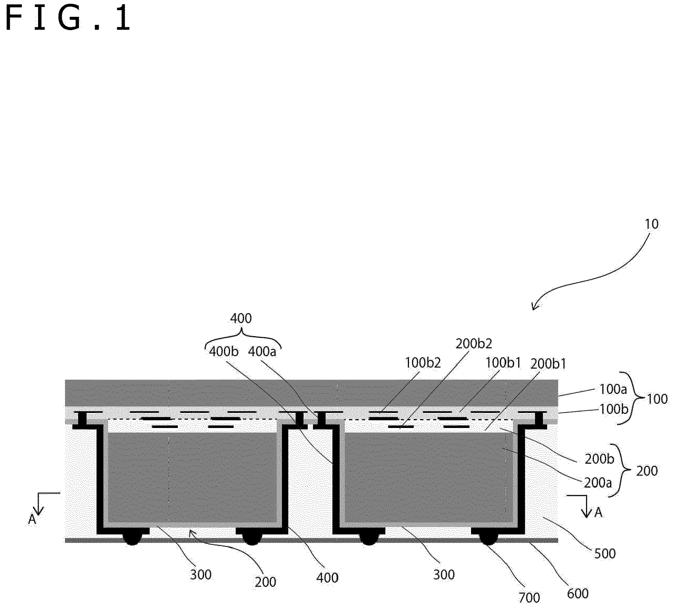

   FIG. 1 is a cross-sectional diagram of a semiconductor device according to example 1 of one embodiment of the present technology.
[FIG. 2]

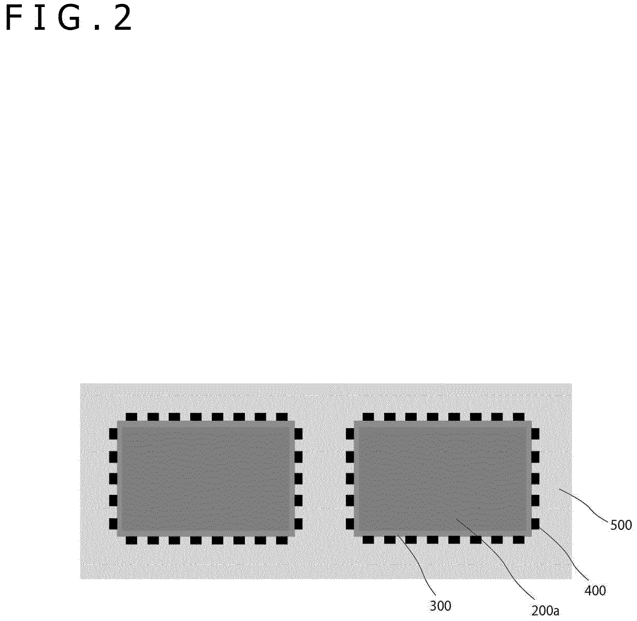

   FIG. 2 is a cross-sectional diagram taken along line A-A in FIG. 1.
[FIG. 3]

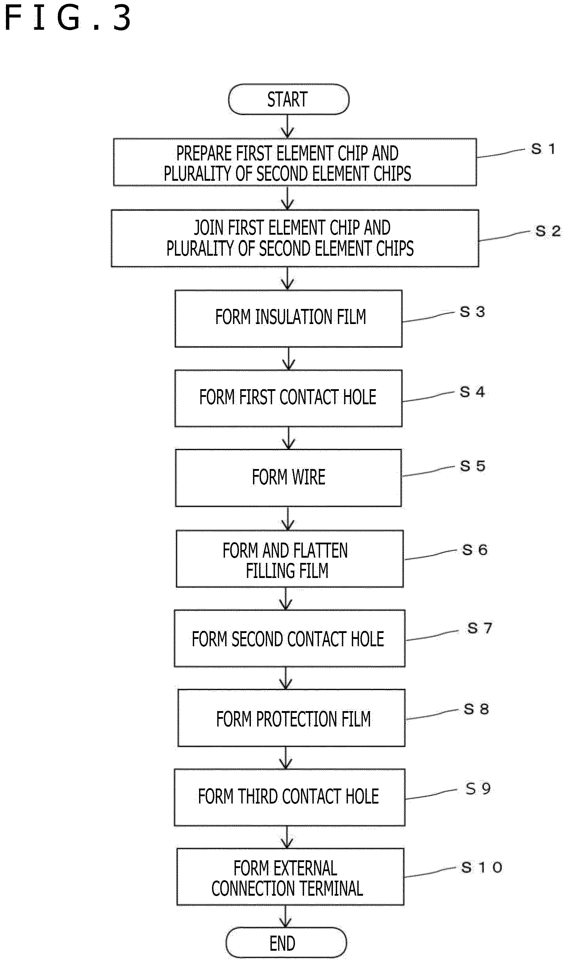

   FIG. 3 is a flowchart for explaining a manufacturing method of the semiconductor device in FIG. 1.
[FIG. 4]

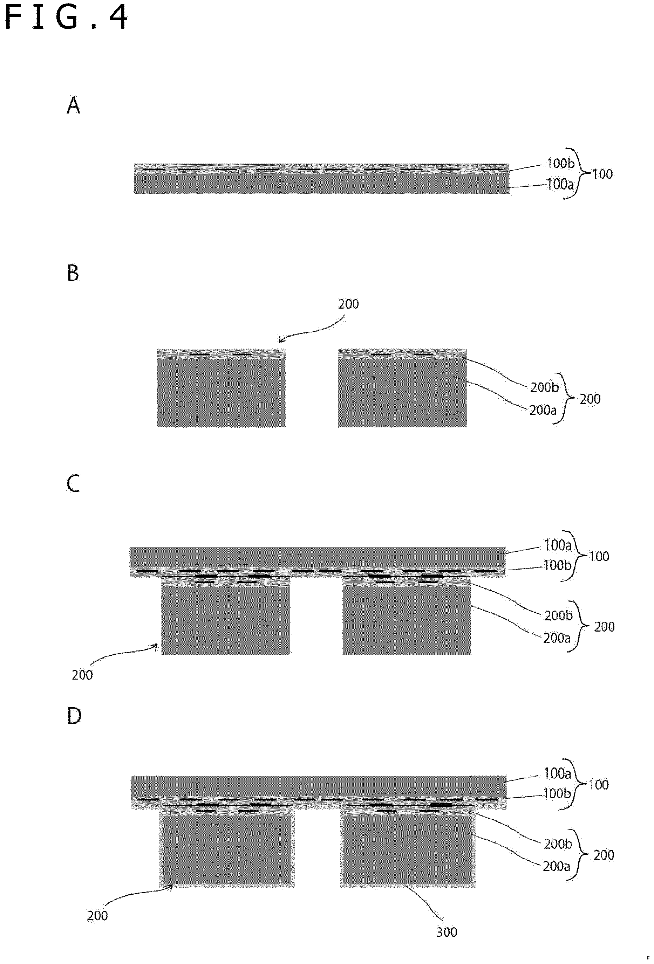

   FIG. 4A to FIG. 4D are each a step cross-sectional diagram of the manufacturing method of the semiconductor device in FIG. 1.
[FIG. 5]

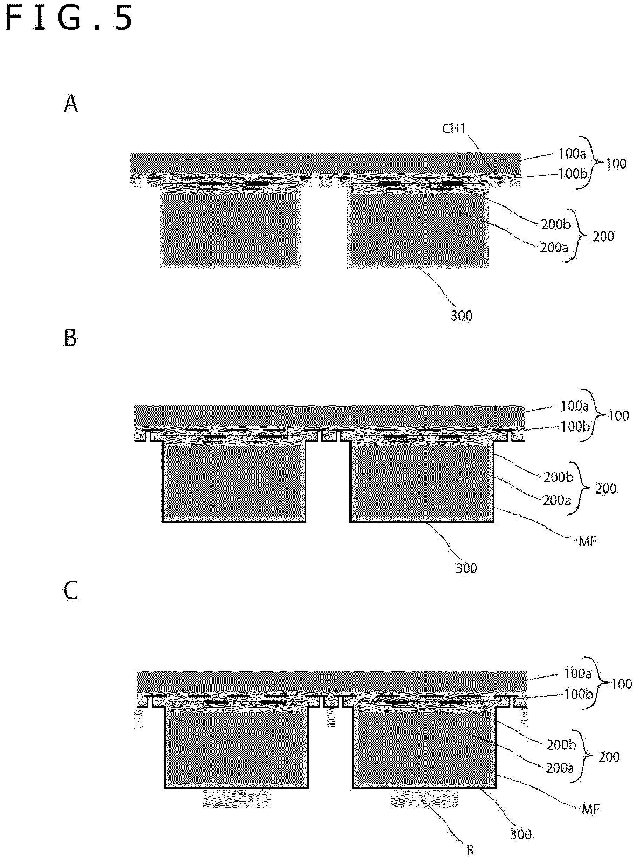

   FIG. 5A to FIG. 5C are each a step cross-sectional diagram of the manufacturing method of the semiconductor device in FIG. 1.
[FIG. 6]

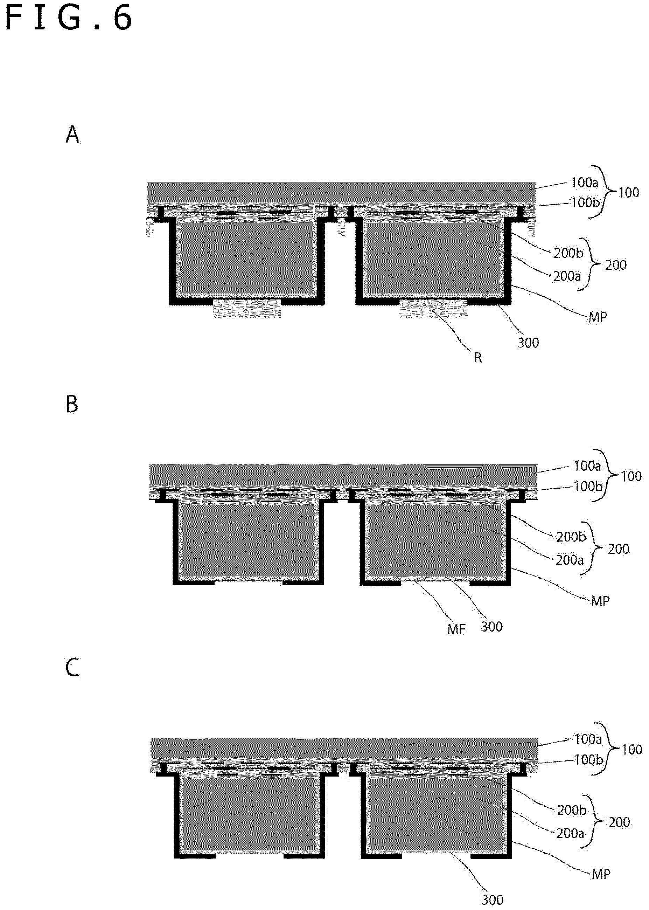

   FIG. 6A to FIG. 6C are each a step cross-sectional diagram of the manufacturing method of the semiconductor device in FIG. 1.
[FIG. 7]

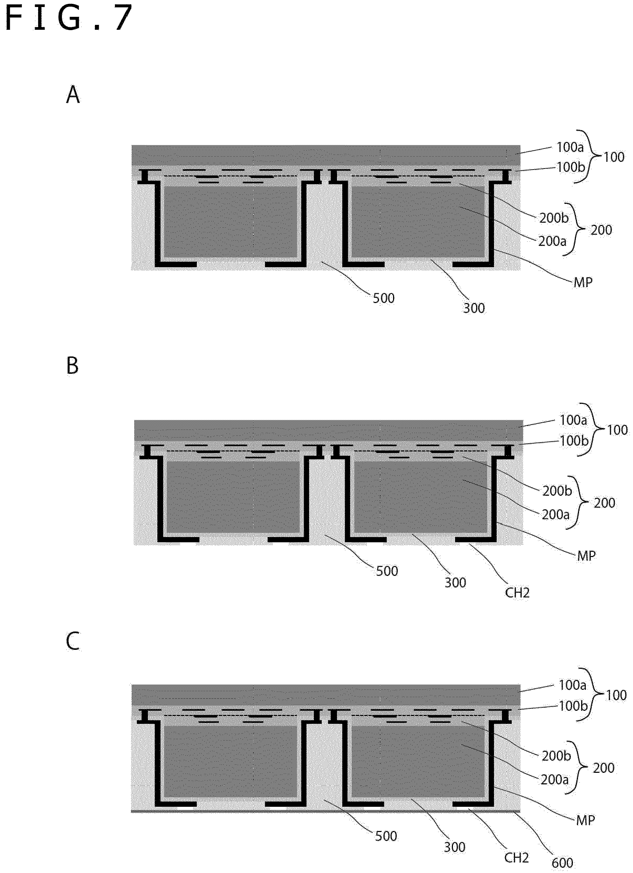

   FIG. 7A to FIG. 7C are each a step cross-sectional diagram of the manufacturing method of the semiconductor device in FIG. 1.
[FIG. 8]

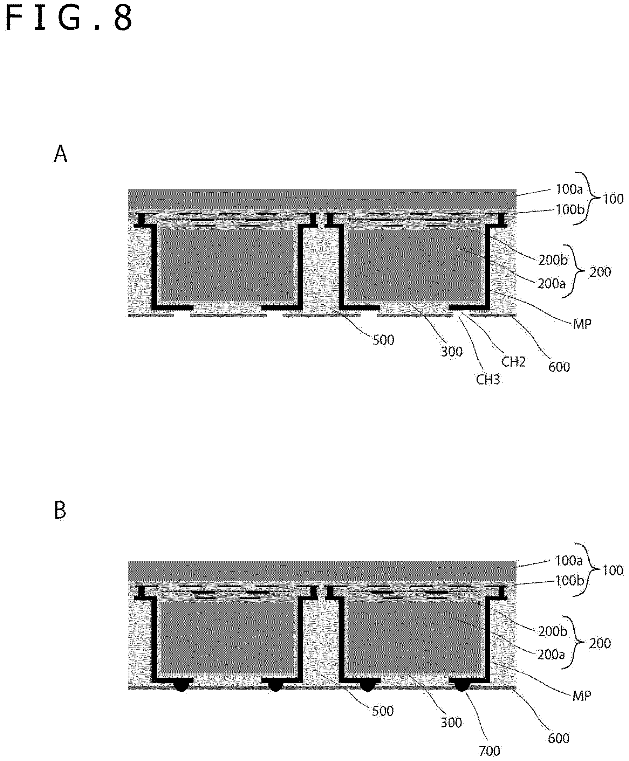

   FIG. 8A and FIG. 8B are each a step cross-sectional diagram of the manufacturing method of the semiconductor device in FIG. 1.
[FIG. 9]

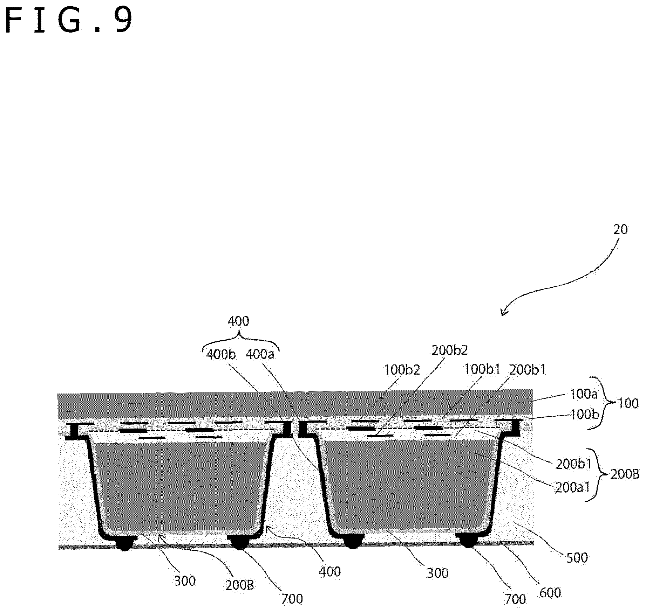

   FIG. 9 is a cross-sectional diagram of a semiconductor device according to example 2 of one embodiment of the present technology.
[FIG. 10]

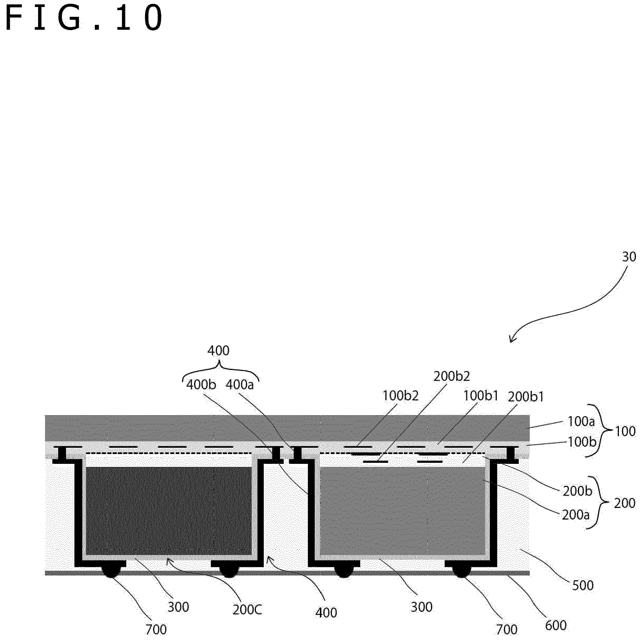

   FIG. 10 is a cross-sectional diagram of a semiconductor device according to example 3 of one embodiment of the present technology.
[FIG. 11]

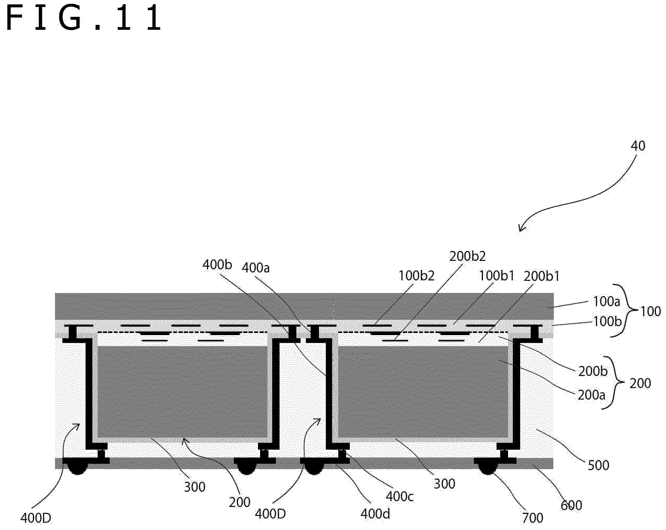

   FIG. 11 is a cross-sectional diagram of a semiconductor device according to example 4 of one embodiment of the present technology.
[FIG. 12]

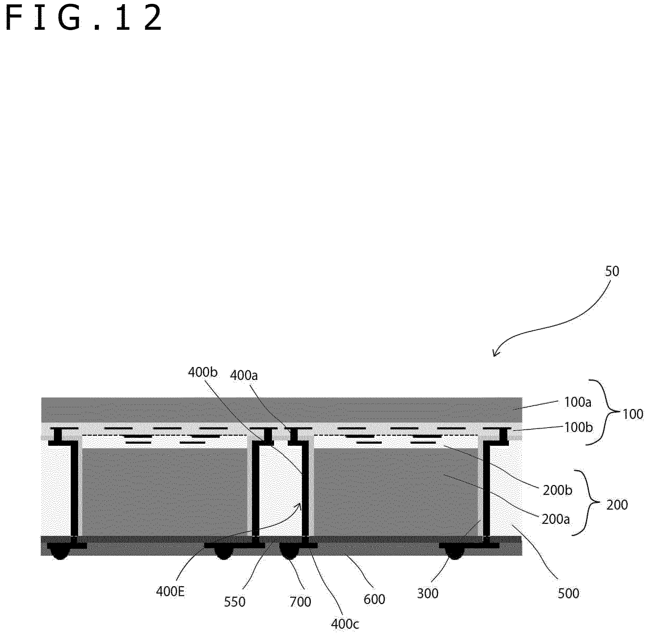

   FIG. 12 is a cross-sectional diagram of a semiconductor device according to example 5 of one embodiment of the present technology.
[FIG. 13]

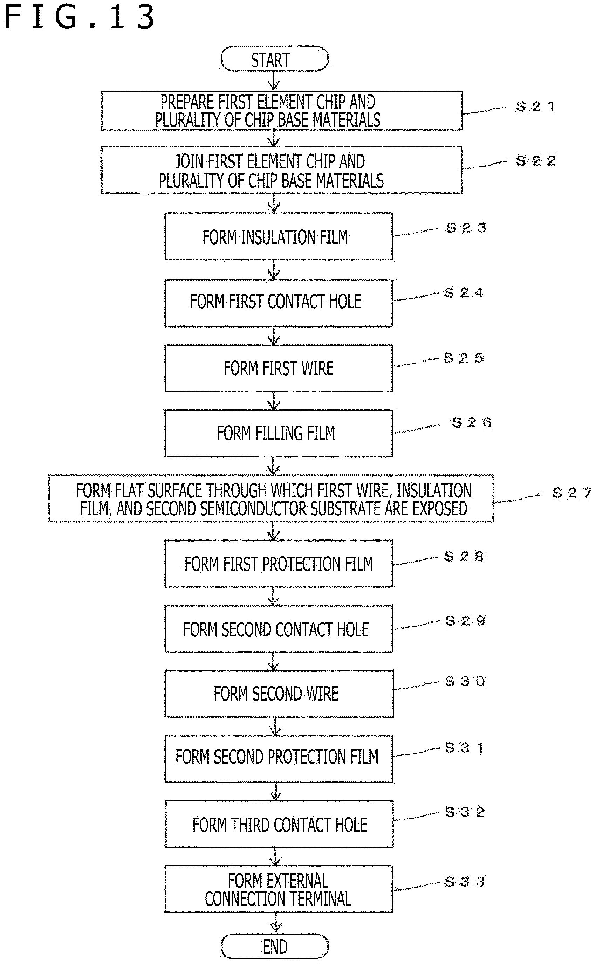

   FIG. 13 is a flowchart for explaining a manufacturing method of the semiconductor device in FIG. 12.
[FIG. 14]

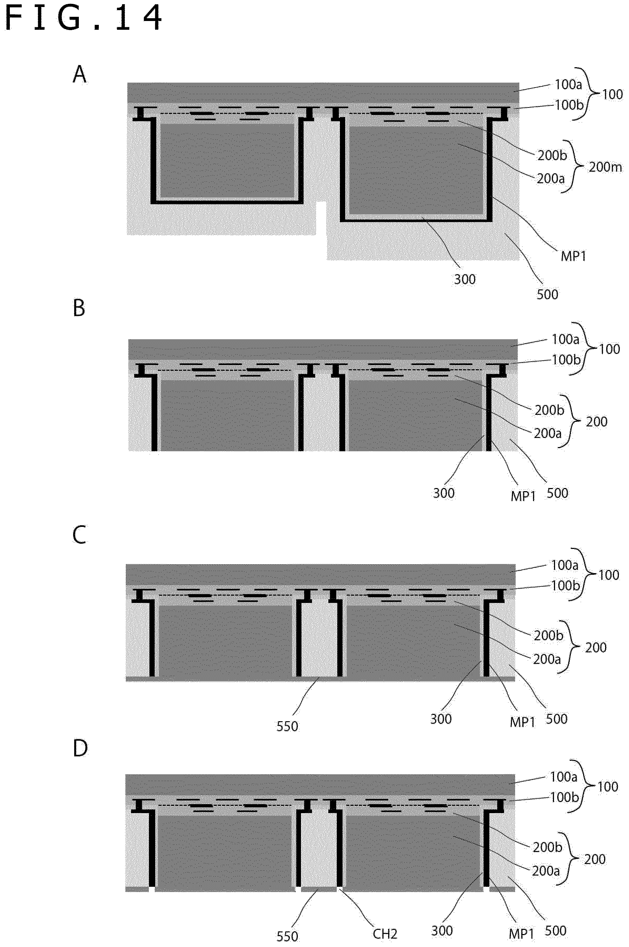

   FIG. 14A to FIG. 14D are each a step cross-sectional diagram of the manufacturing method of the semiconductor device in FIG. 12.
[FIG. 15]

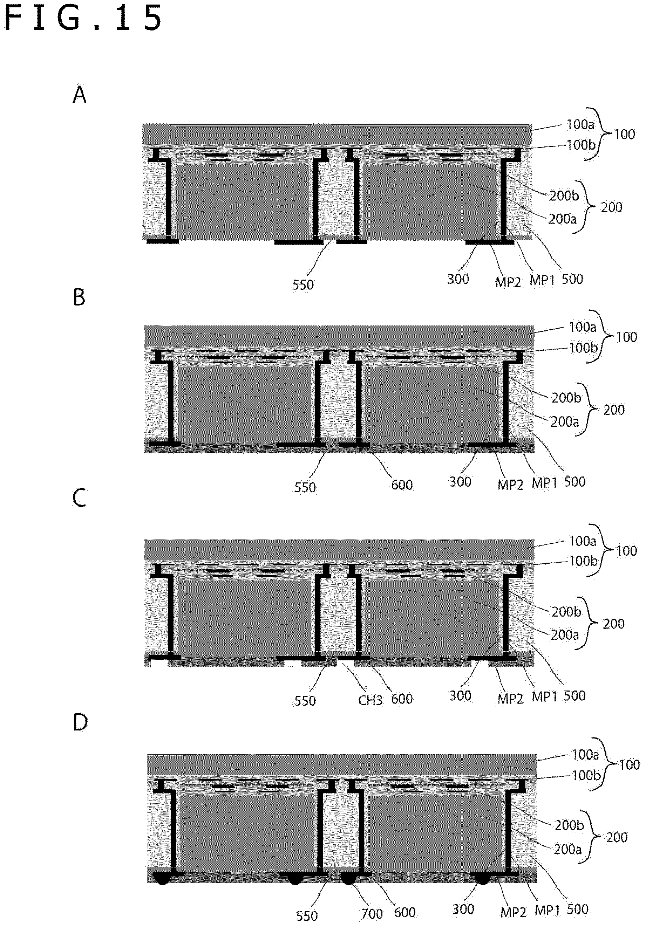

   FIG. 15A to FIG. 15D are each a step cross-sectional diagram of the manufacturing method of the semiconductor device in FIG. 12.
[FIG. 16]

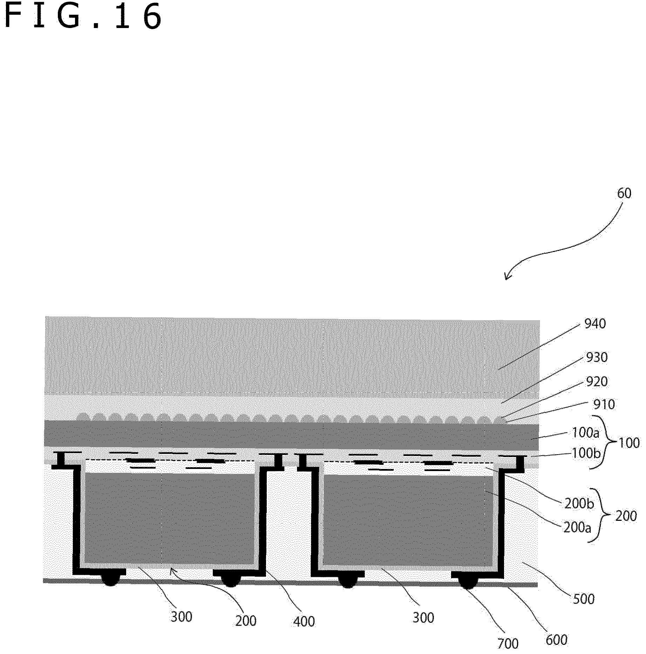

   FIG. 16 is a cross-sectional diagram of a semiconductor device according to example 6 of one embodiment of the present technology.
[FIG. 17]

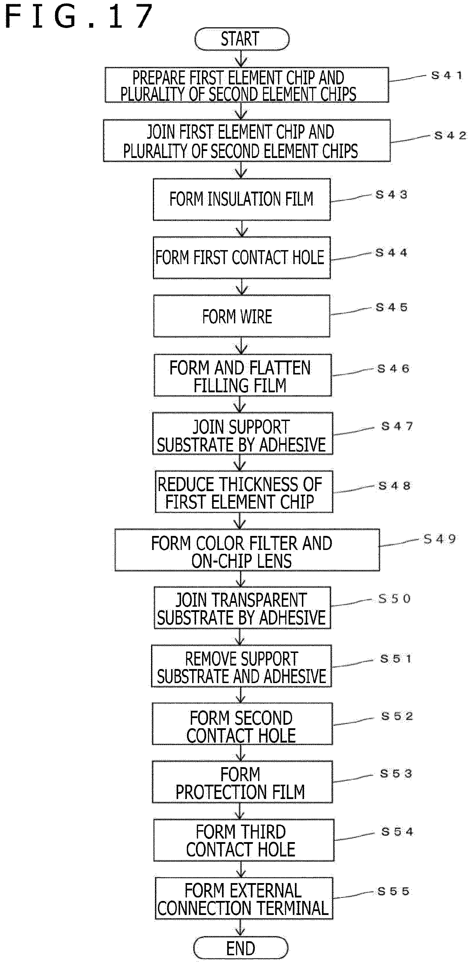

   FIG. 17 is a flowchart for explaining a manufacturing method of the semiconductor device in FIG. 16.
[FIG. 18]

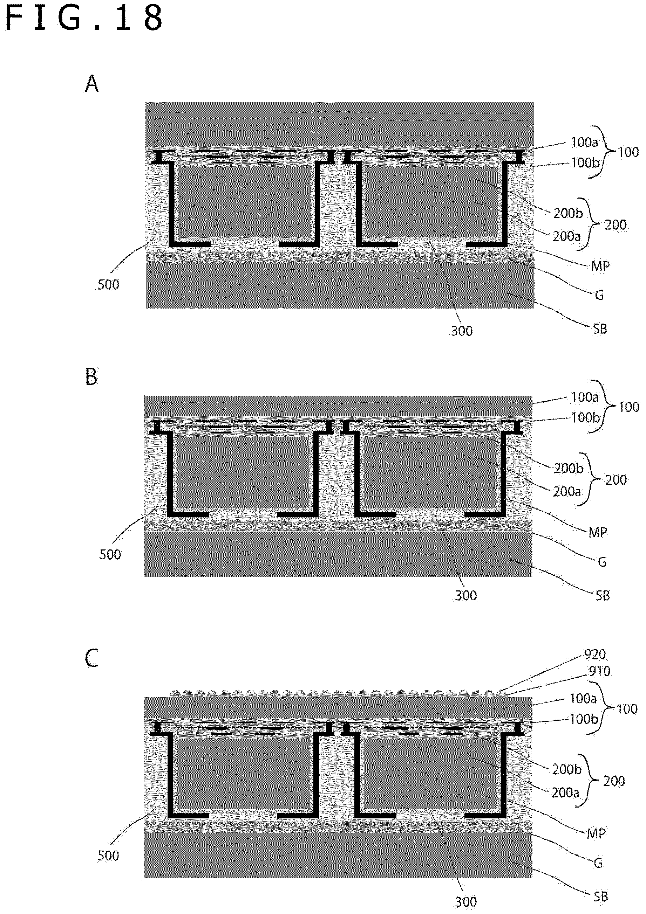

   FIG. 18A to FIG. 18C are each a step cross-sectional diagram of the manufacturing method of the semiconductor device in FIG. 16.
[FIG. 19]

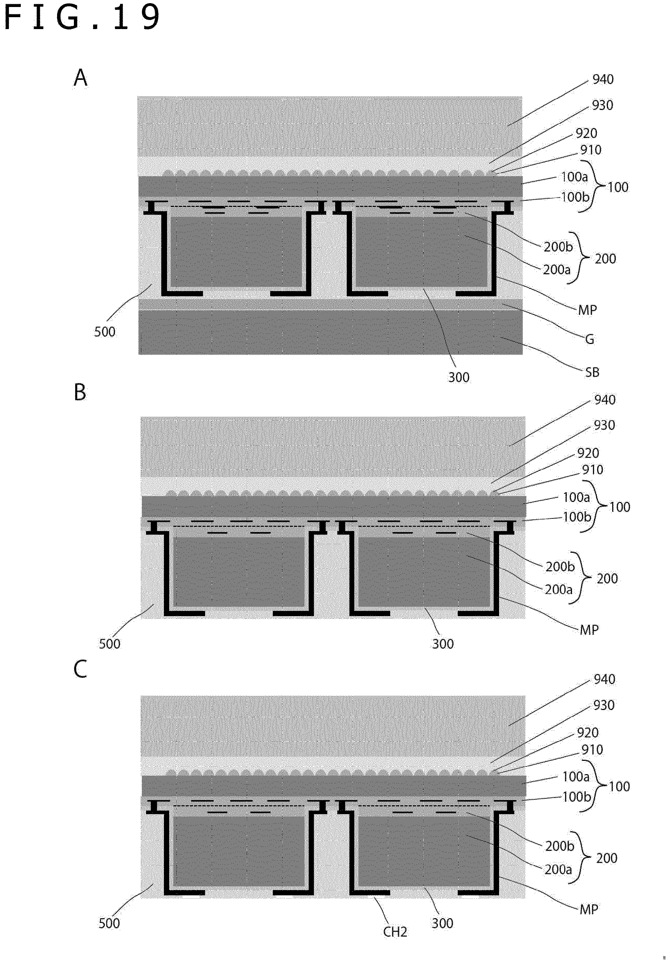

   FIG. 19A to FIG. 19C are each a step cross-sectional diagram of the manufacturing method of the semiconductor device in FIG. 16.
[FIG. 20]

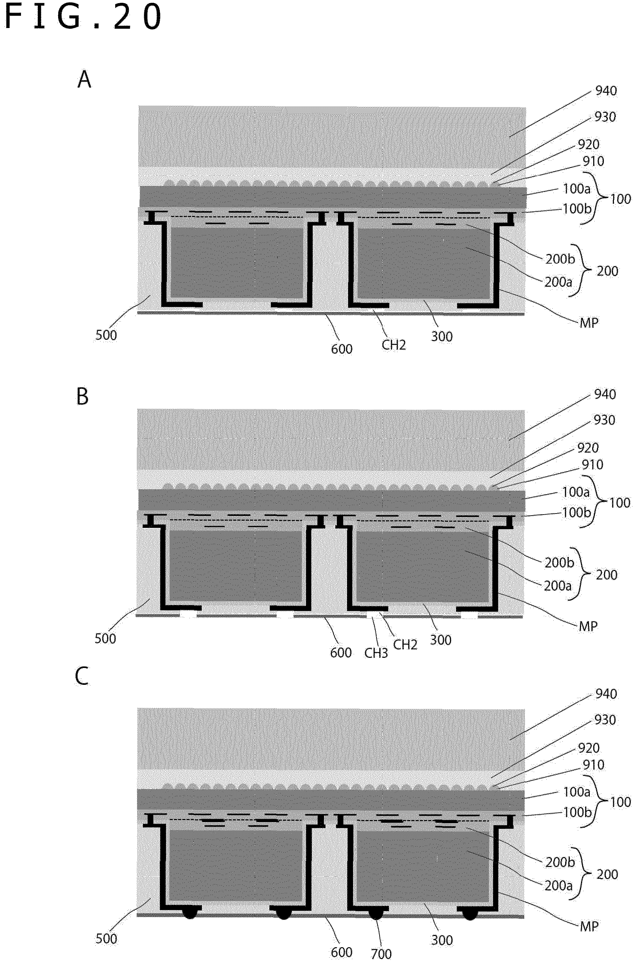

   FIG. 20A to FIG. 20C are each a step cross-sectional diagram of the manufacturing method of the semiconductor device in FIG. 16.
[FIG. 21]

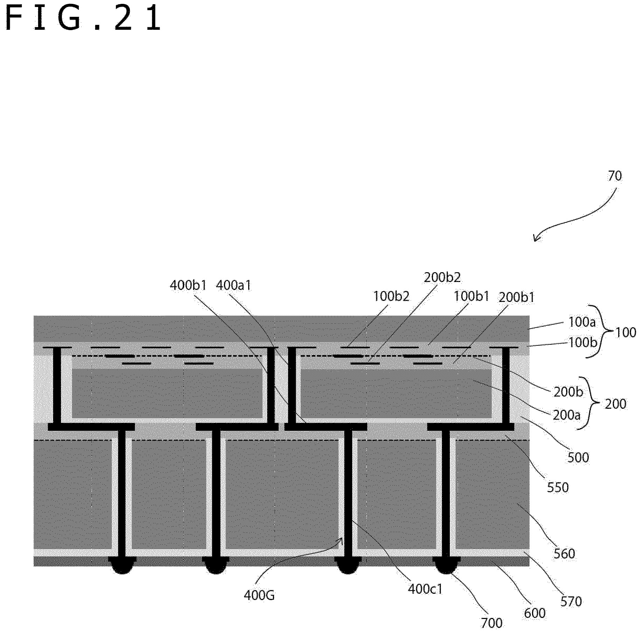

   FIG. 21 is a cross-sectional diagram of a semiconductor device according to example 7 of one embodiment of the present technology.
[FIG. 22]

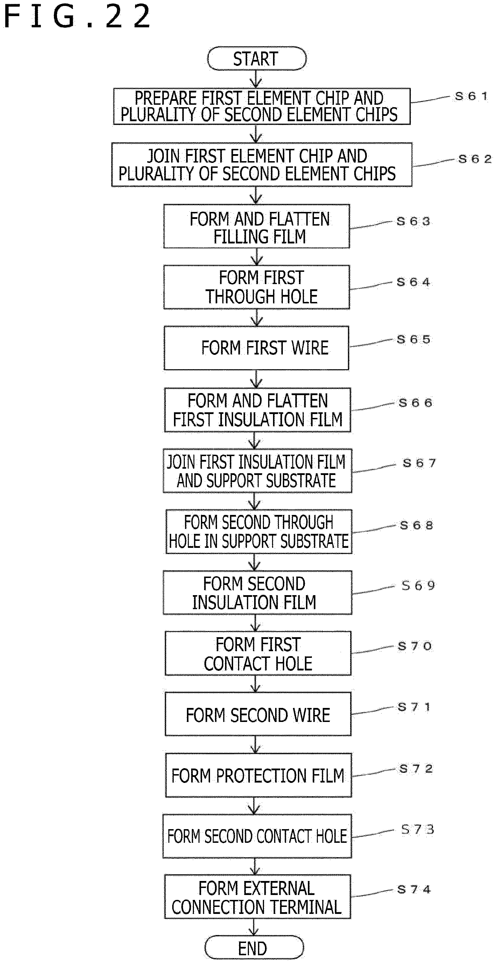

   FIG. 22 is a flowchart for explaining a manufacturing method of the semiconductor device in FIG. 21.
[FIG. 23]

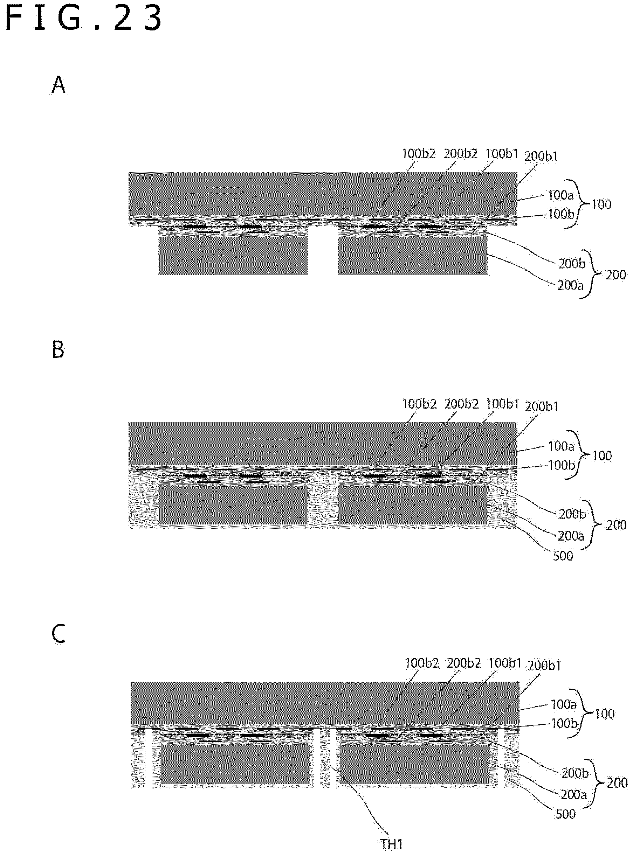

   FIG. 23A to FIG. 23C are each a step cross-sectional diagram of the manufacturing method of the semiconductor device in FIG. 21.
[FIG. 24]

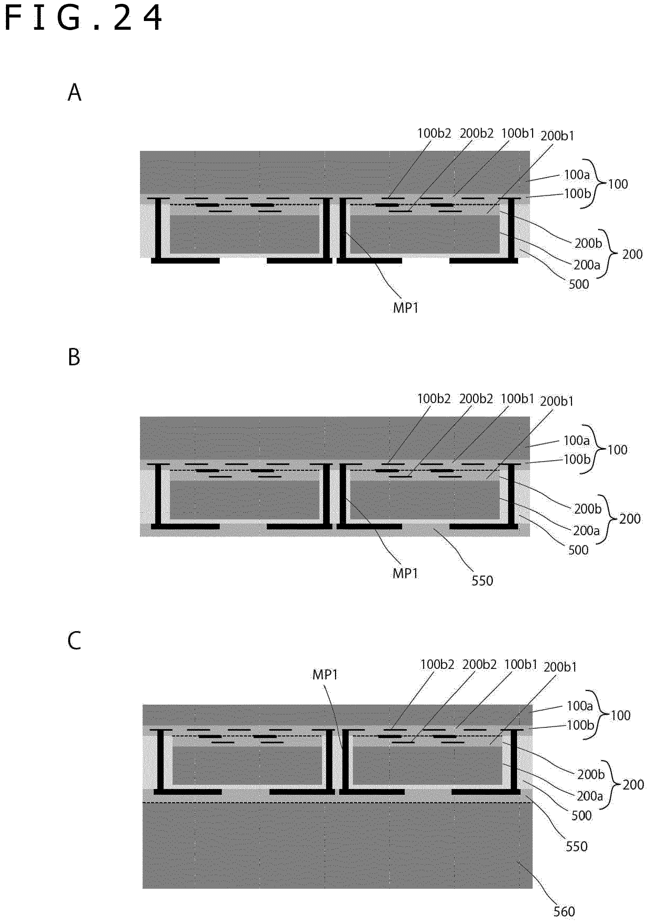

   FIG. 24A to FIG. 24C are each a step cross-sectional diagram of the manufacturing method of the semiconductor device in FIG. 21.
[FIG. 25]

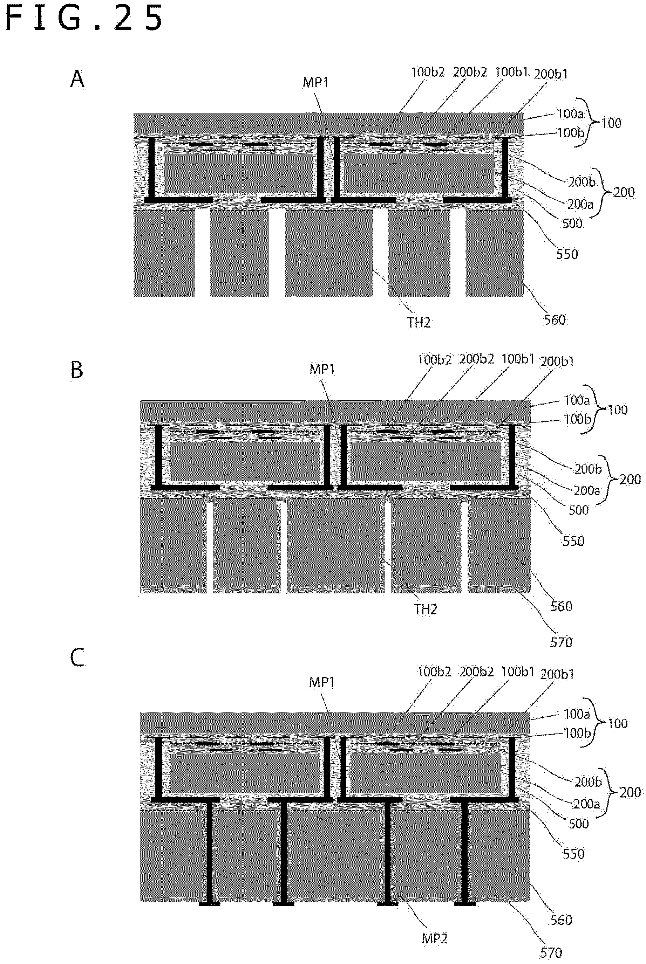

   FIG. 25A to FIG. 25C are each a step cross-sectional diagram of the manufacturing method of the semiconductor device in FIG. 21.
[FIG. 26]

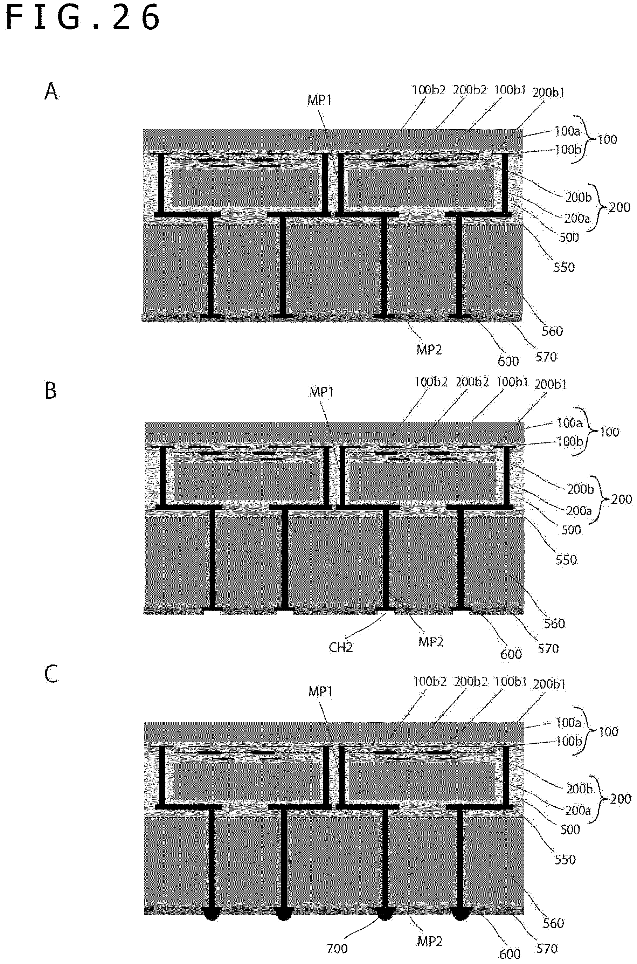

   FIG. 26A to FIG. 26C are each a step cross-sectional diagram of the manufacturing method of the semiconductor device in FIG. 21.
[FIG. 27]

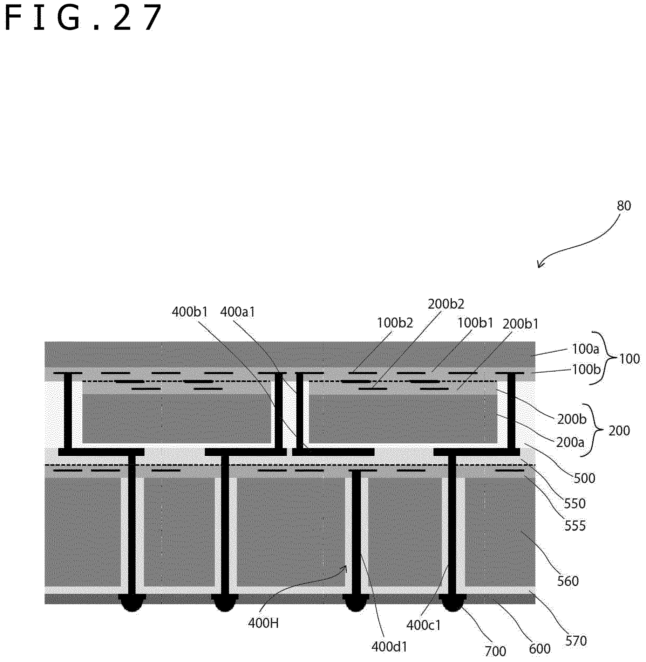

   FIG. 27 is a cross-sectional diagram of a semiconductor device according to example 8 of one embodiment of the present technology.
[FIG. 28]

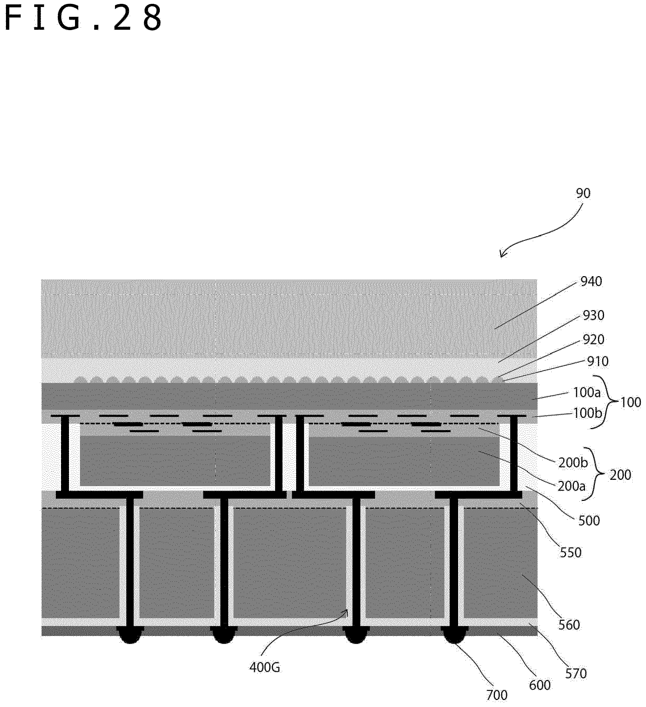

   FIG. 28 is a cross-sectional diagram of a semiconductor device according to example 9 of one embodiment of the present technology.
[FIG. 29]

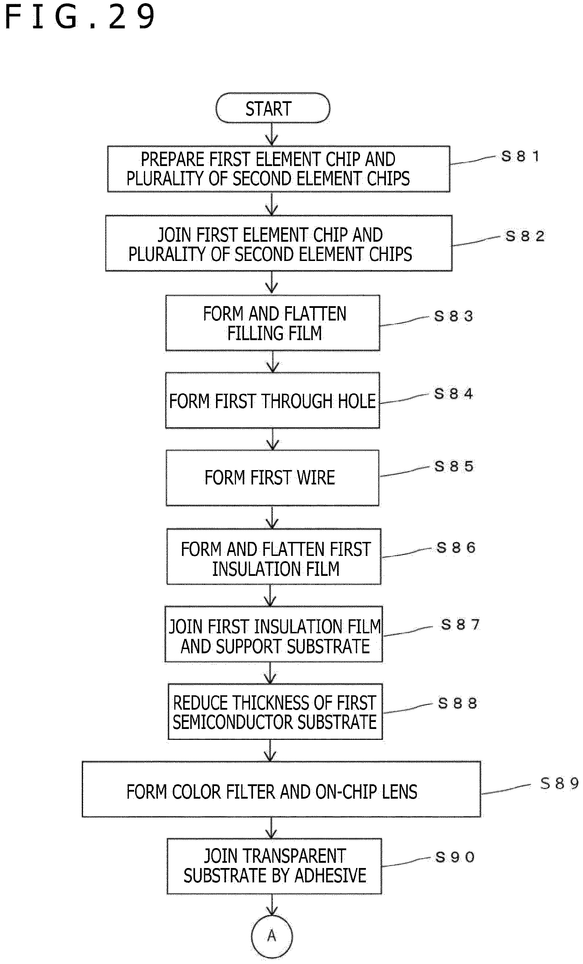

   FIG. 29 is a first half of a flowchart for explaining a manufacturing method of the semiconductor device in FIG. 28.
[FIG. 30]

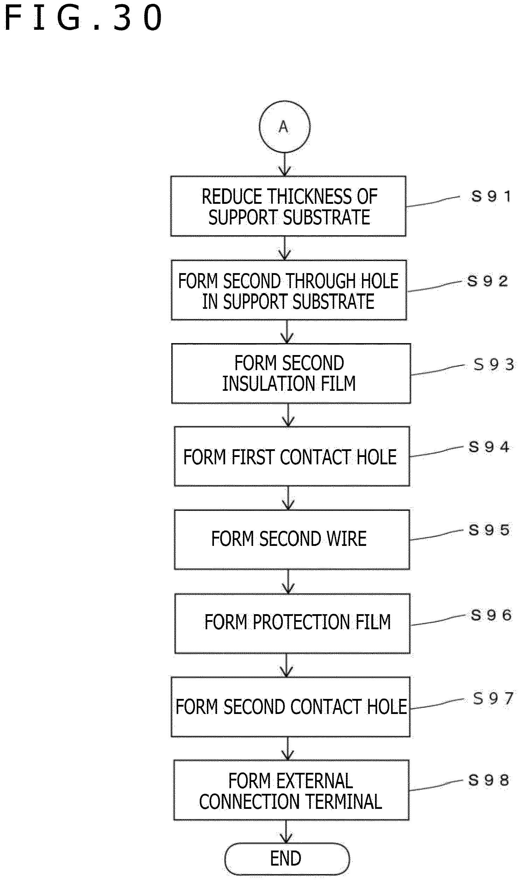

   FIG. 30 is a second half of a flowchart for explaining the manufacturing method of the semiconductor device in FIG. 28.
[FIG. 31]

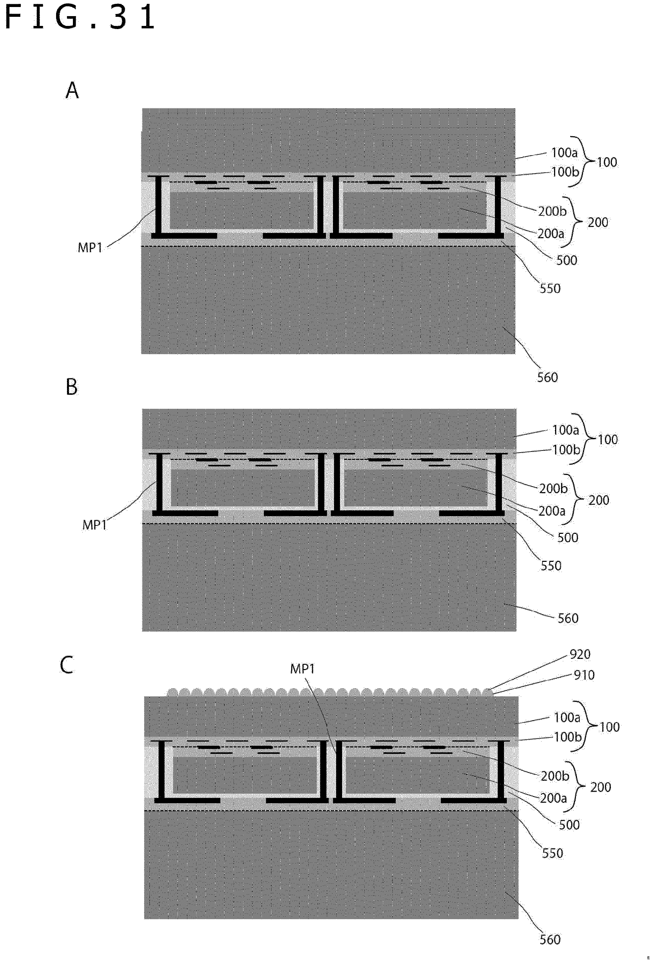

   FIG. 31A to FIG. 31C are each a step cross-sectional diagram of the manufacturing method of the semiconductor device in FIG. 28.
[FIG. 32]

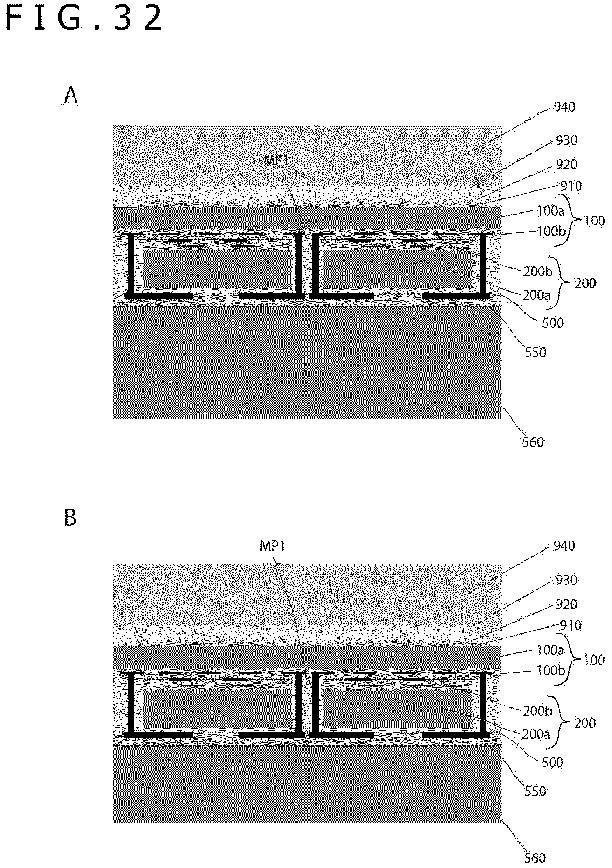

   FIG. 32A and FIG. 32B are each a step cross-sectional diagram of the manufacturing method of the semiconductor device in FIG. 28.
[FIG. 33]

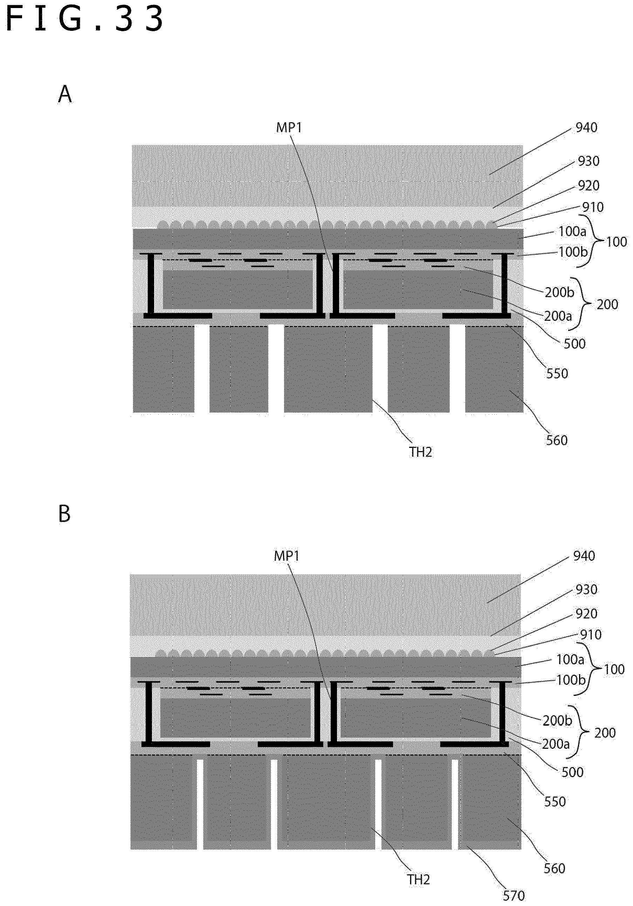

   FIG. 33A and FIG. 33B are each a step cross-sectional diagram of the manufacturing method of the semiconductor device in FIG. 28.
[FIG. 34]

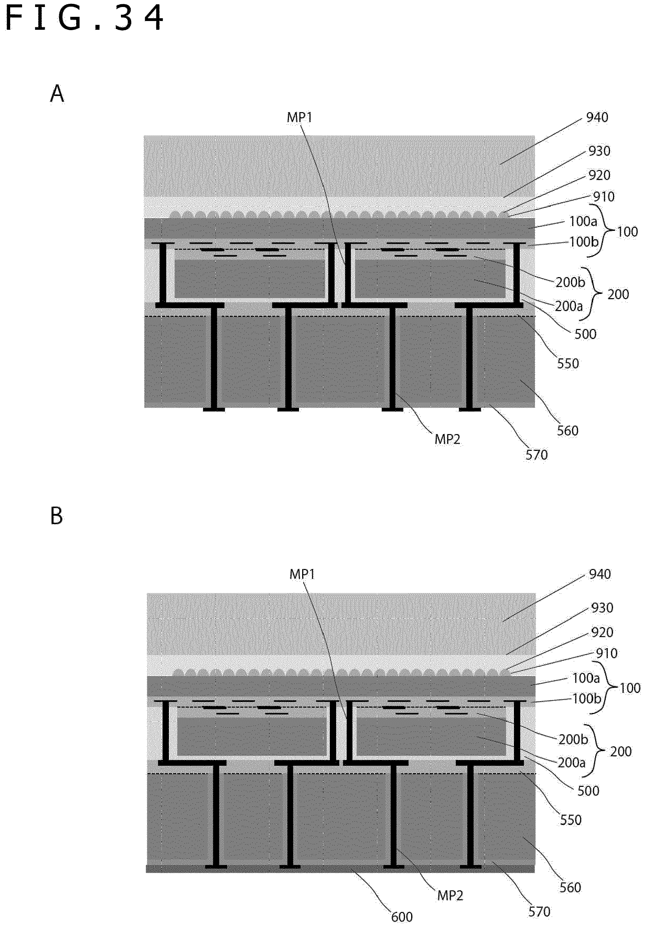

   FIG. 34A and FIG. 34B are each a step cross-sectional diagram of the manufacturing method of the semiconductor device in FIG. 28.
[FIG. 35]

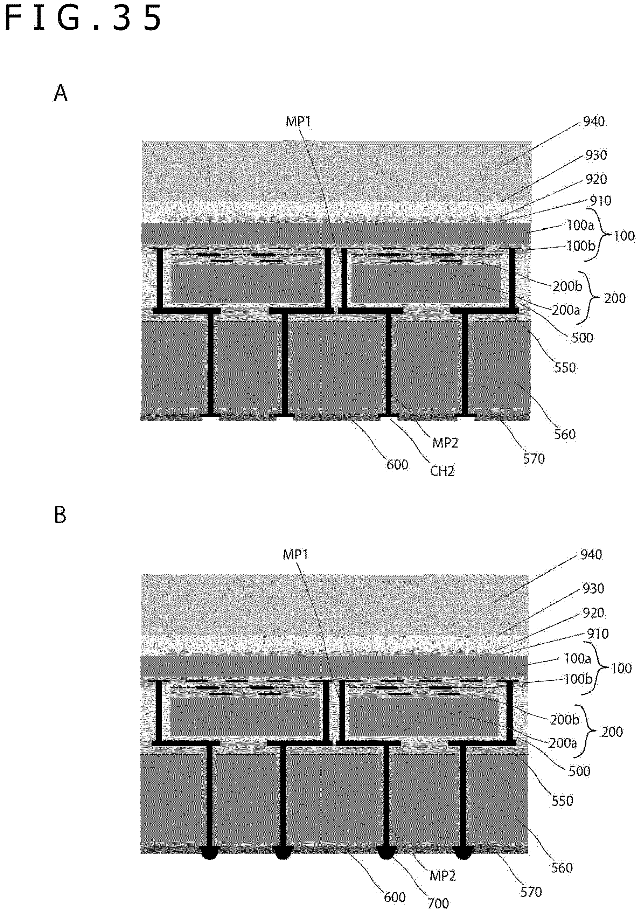

   FIG. 35A and FIG. 35B are each a step cross-sectional diagram of the manufacturing method of the semiconductor device in FIG. 28.
[FIG. 36]

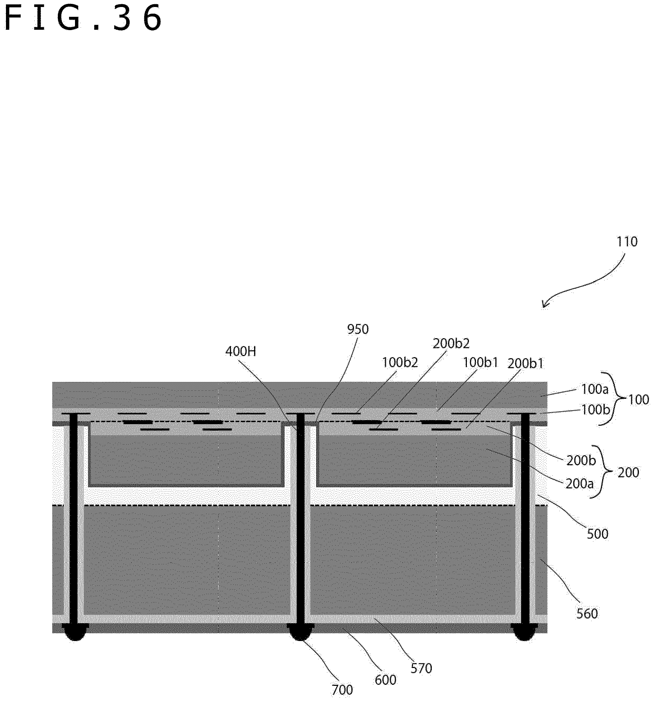

   FIG. 36 is a cross-sectional diagram of a semiconductor device according to example 10 of one embodiment of the present technology.
[FIG. 37]

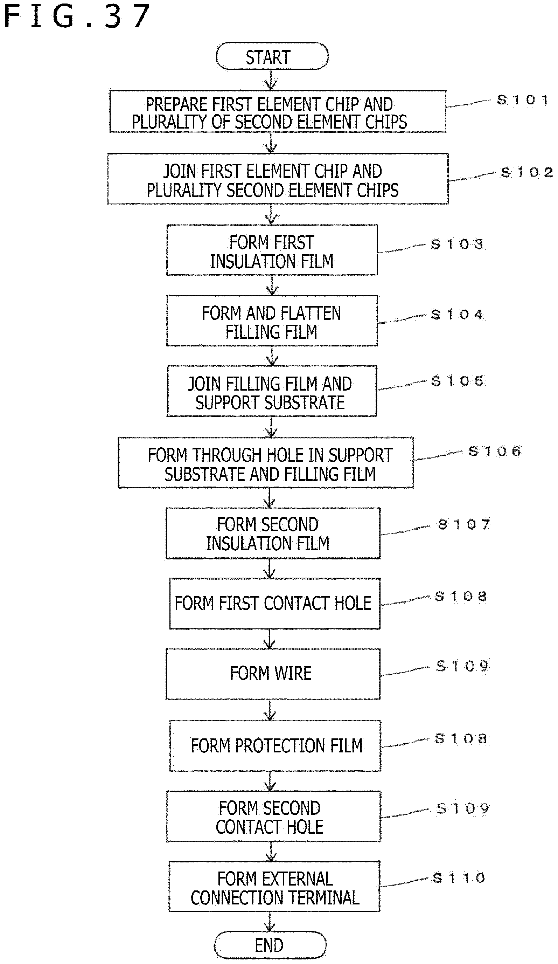

   FIG. 37 is a flowchart for explaining a manufacturing method of the semiconductor device in FIG. 36.
[FIG. 38]

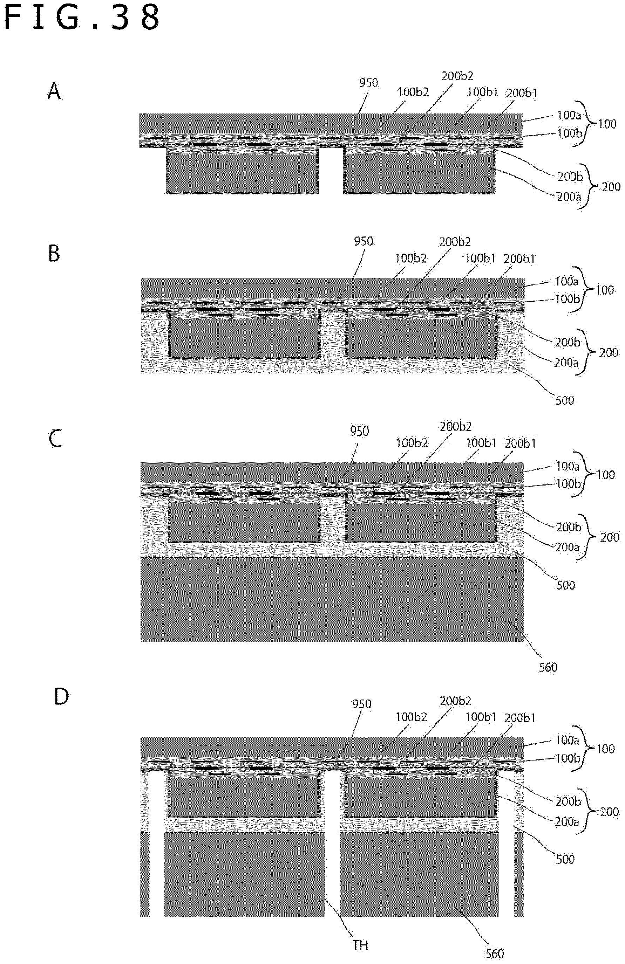

   FIG. 38A to FIG. 38D are each a step cross-sectional diagram of the manufacturing method of the semiconductor device in FIG. 36.
[FIG. 39]

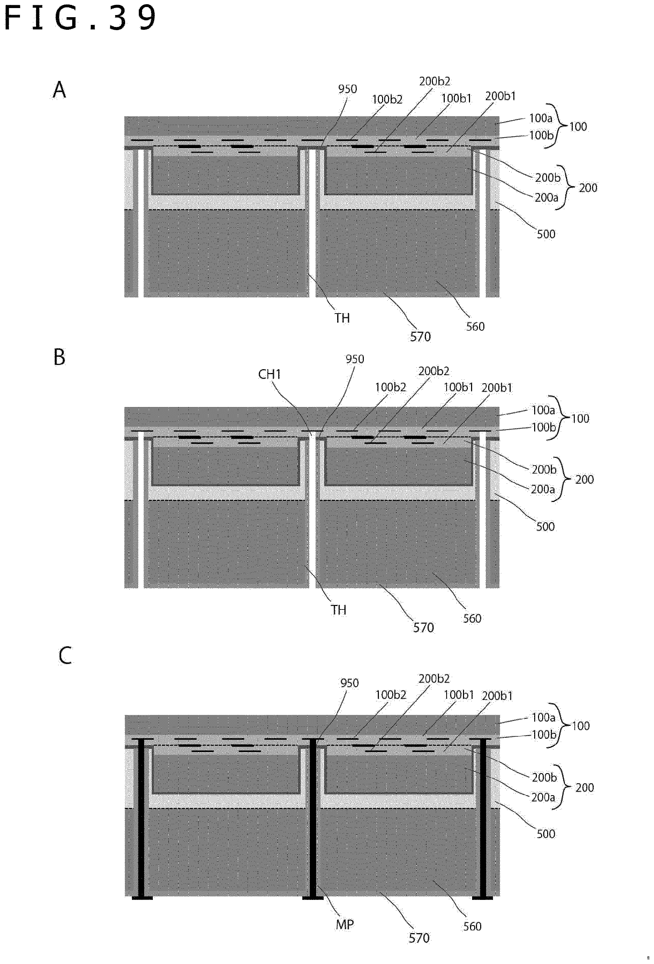

   FIG. 39A to FIG. 39C are each a step cross-sectional diagram of the manufacturing method of the semiconductor device in FIG. 36.
[FIG. 40]

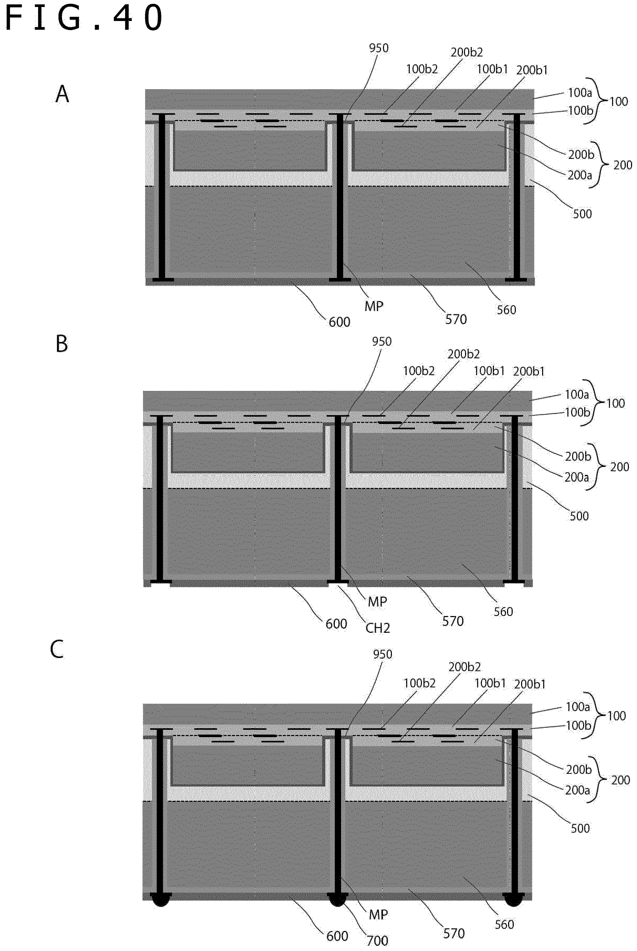

   FIG. 40A to FIG. 40C are each a step cross-sectional diagram of the manufacturing method of the semiconductor device in FIG. 36.
[FIG. 41]

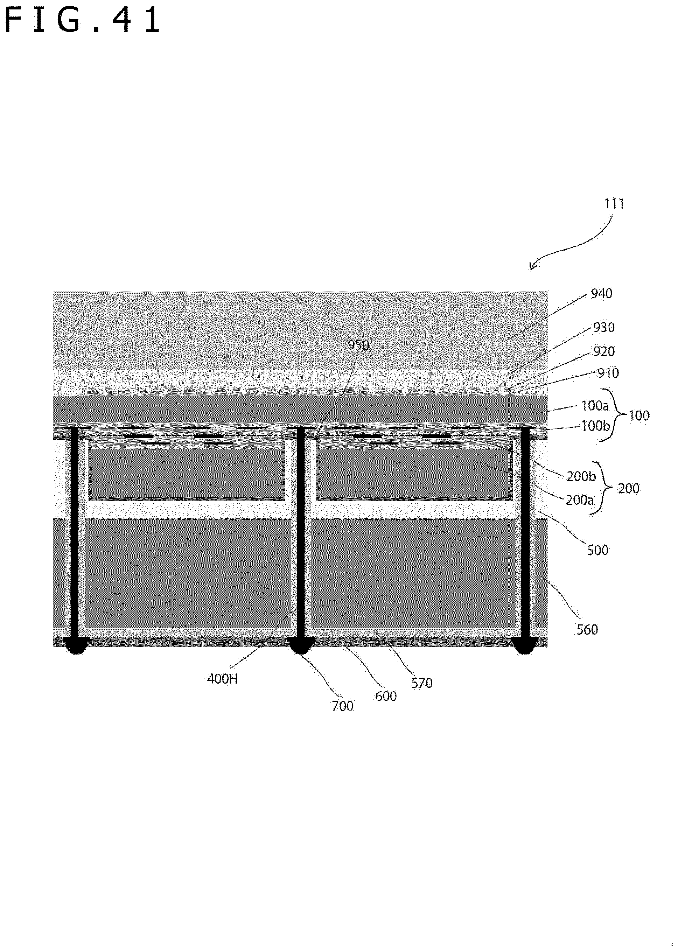

   FIG. 41 is a cross-sectional diagram of a semiconductor device according to example 11 of one embodiment of the present technology.
[FIG. 42]

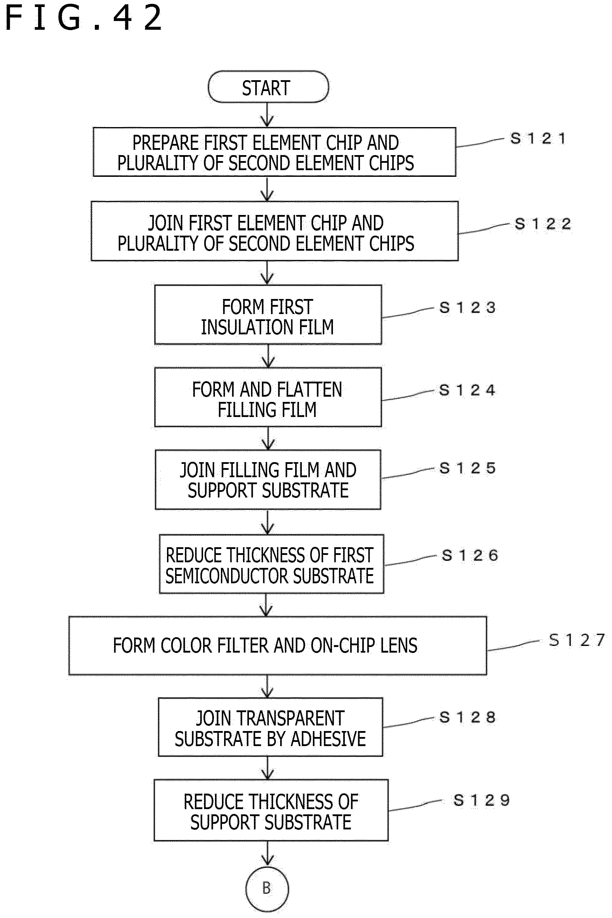

   FIG. 42 is a first half of a flowchart for explaining a manufacturing method of the semiconductor device in FIG. 41.
[FIG. 43]

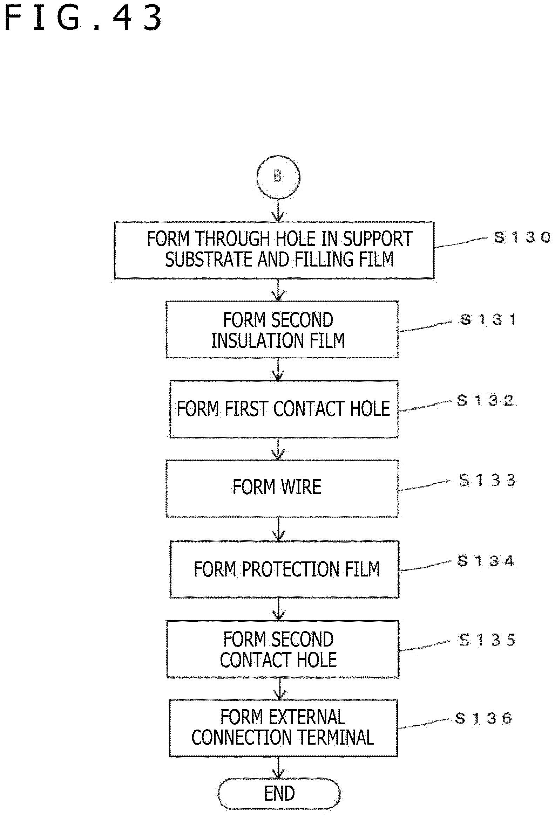

   FIG. 43 is a second half of the flowchart for explaining the manufacturing method of the semiconductor device in FIG. 41.
[FIG. 44]

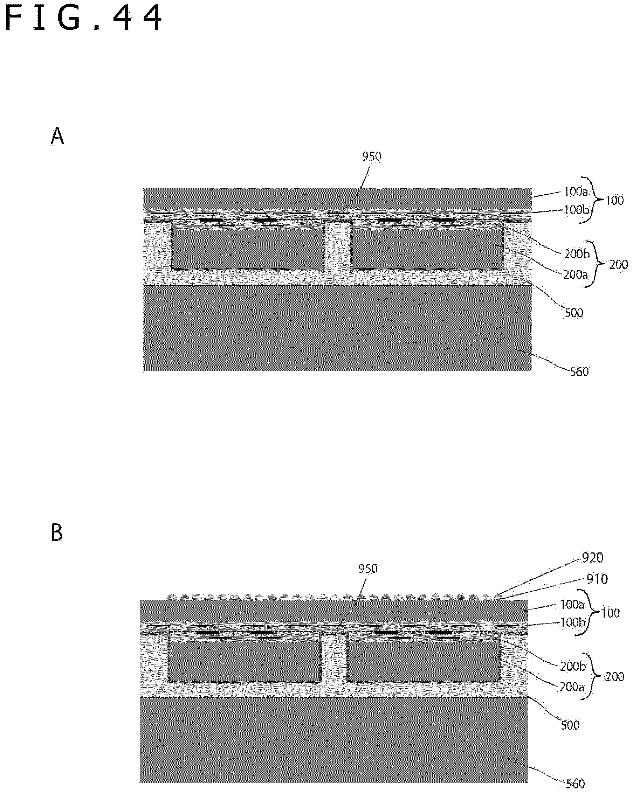

   FIG. 44A and FIG. 44B are each a step cross-sectional diagram of the manufacturing method of the semiconductor device in FIG. 41.
[FIG. 45]

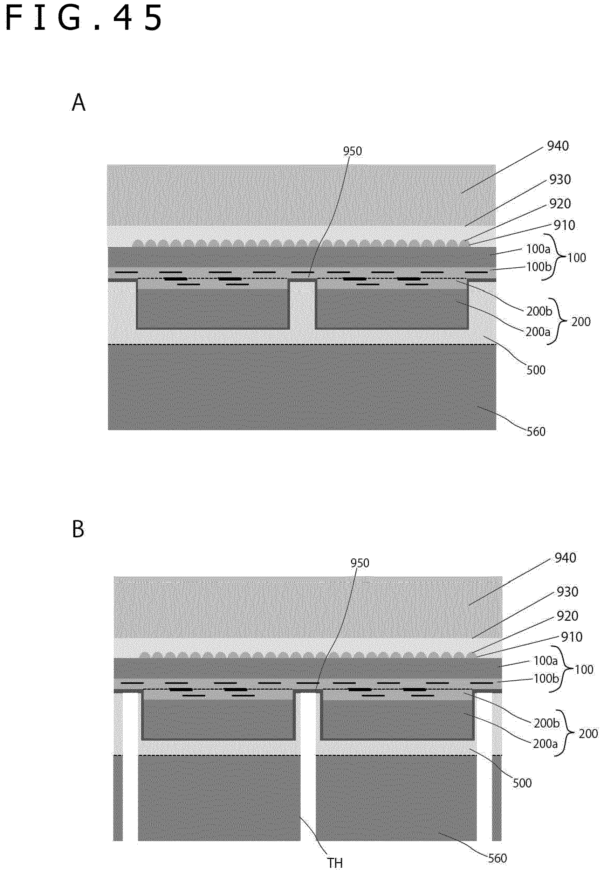

   FIG. 45A and FIG. 45B are each a step cross-sectional diagram of the manufacturing method of the semiconductor device in FIG. 41.
[FIG. 46]

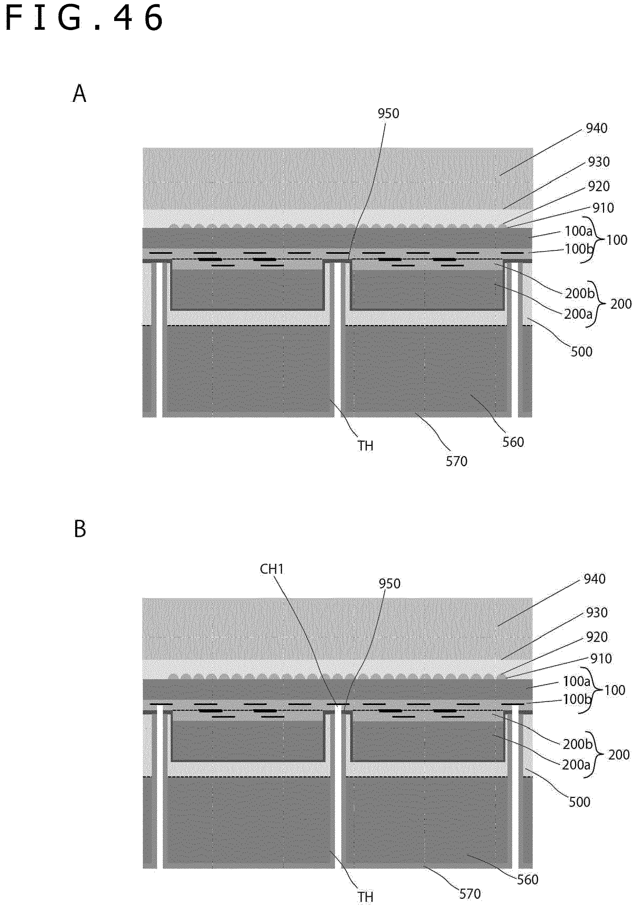

   FIG. 46A and FIG. 46B are each a step cross-sectional diagram of the manufacturing method of the semiconductor device in FIG. 41.
[FIG. 47]

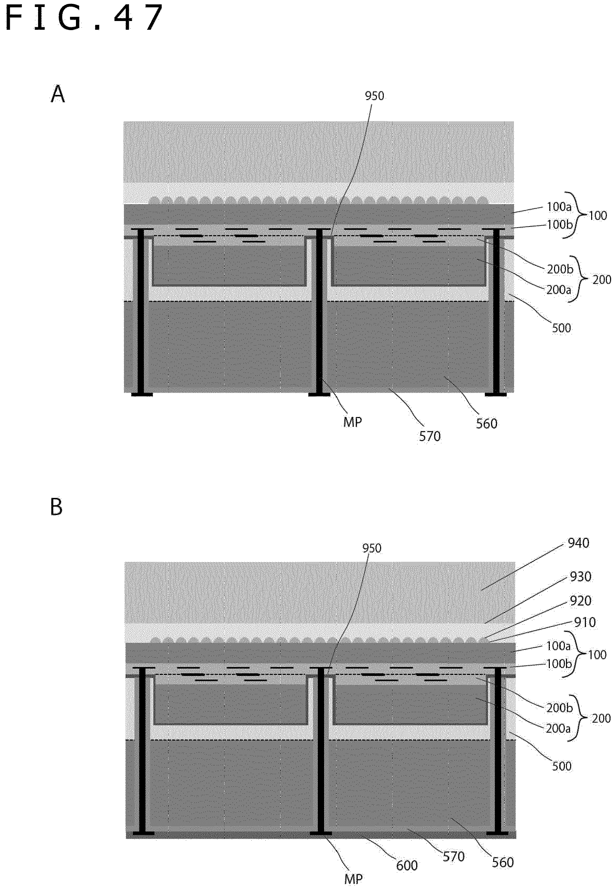

   FIG. 47A and FIG. 47B are each a step cross-sectional diagram of the manufacturing method of the semiconductor device in FIG. 41.
[FIG. 48]

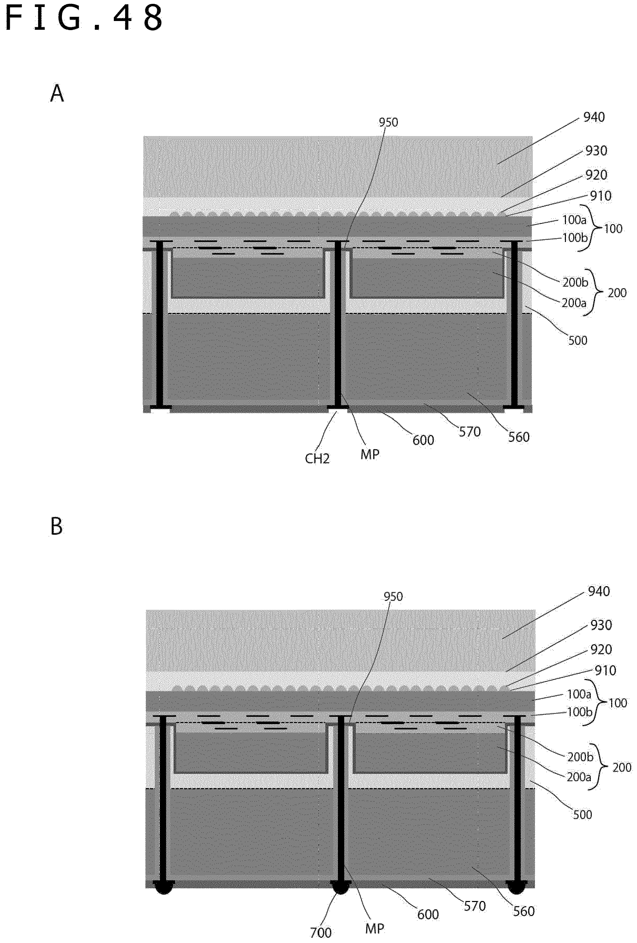

   FIG. 48A and FIG. 48B are each a step cross-sectional diagram of the manufacturing method of the semiconductor device in FIG. 41.
[FIG. 49]

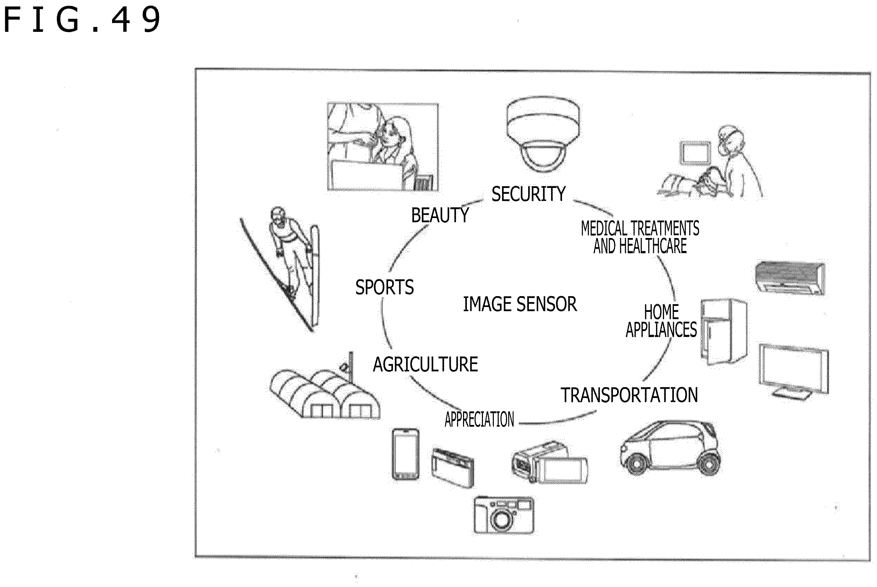

   FIG. 49 is a diagram depicting use examples of a solid-state imaging device to which the present technology is applied.
[FIG. 50]

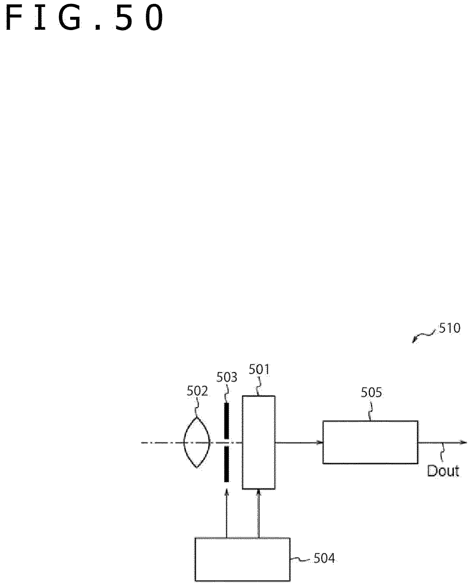

   FIG. 50 is a functional block diagram in one example of an electronic apparatus including a solid-state imaging device to which the present technology is applied.
[FIG. 51]

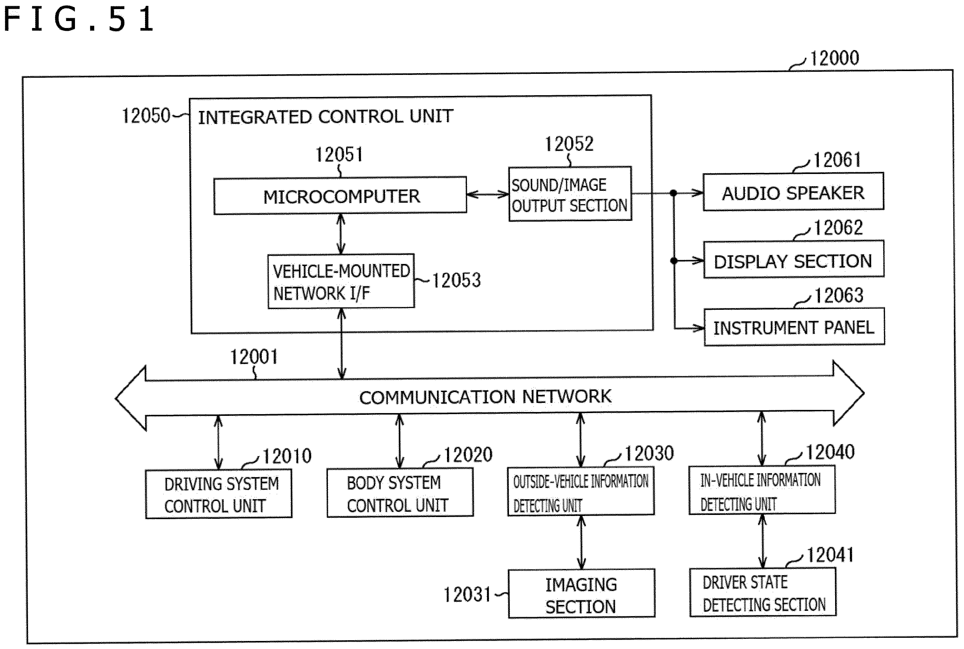

   FIG. 51 is a block diagram depicting an example of a schematic configuration of a vehicle control system.
[FIG. 52]

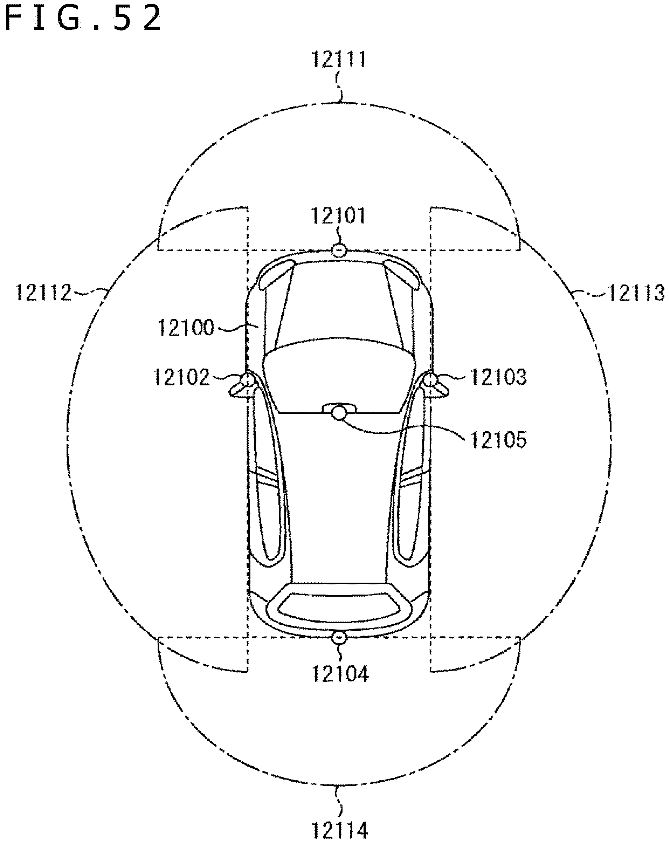

   FIG. 52 is a diagram of assistance in explaining an example of installation positions of an outside-vehicle information detecting section and an imaging section.
[FIG. 53]

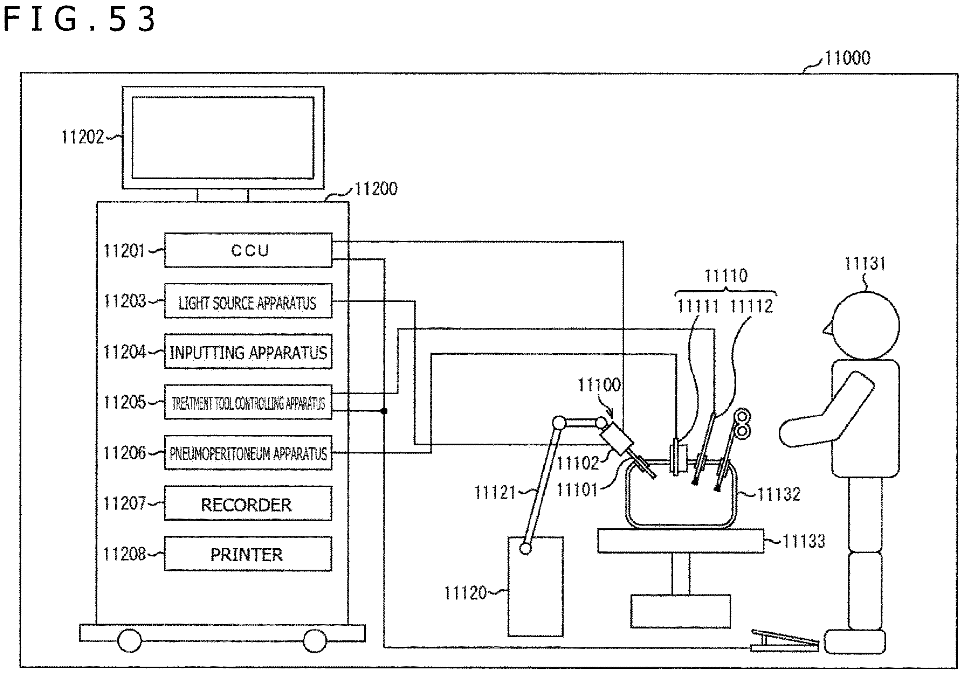

   FIG. 53 is a view depicting an example of a schematic configuration of an endoscopic surgery system.
[FIG. 54]

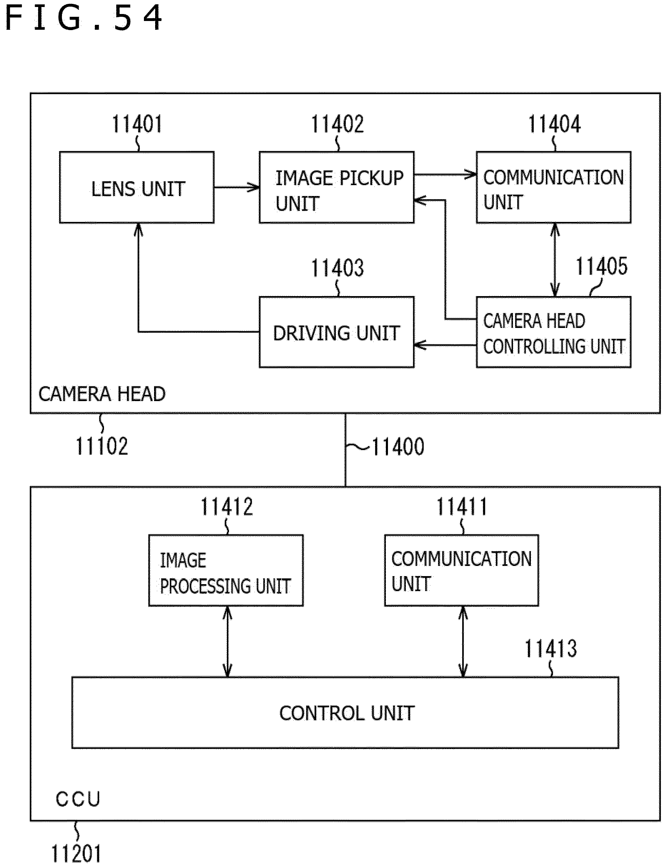

   FIG. 54 is a block diagram depicting an example of a functional configuration of a camera head and a CCU.

### [Description of Embodiment]

A preferred embodiment according to the present technology will hereinafter be described in detail with reference to the accompanying drawings. Note that constituent elements having substantially identical functional configurations in the present description and the drawings are given identical reference signs so as to avoid repetitive explanation. The embodiment described hereinafter presents a typical embodiment of the present technology. It is thus not intended that the scope of the present technology be interpreted in a limited manner by the following embodiment. Even in a case where a plurality of advantageous effects offered by each of a semiconductor device, an apparatus, and a manufacturing method of the semiconductor device according to the present technology are presented in the present description, each of the semiconductor device, the apparatus, and the manufacturing method of the semiconductor device is only required to offer at least one of these advantageous effects. Advantageous effects to be offered are not limited to those presented in the present description only by way of example. Other advantageous effects may be additionally offered.

In addition, the description will be presented in the following order.
0. Introduction
1. Semiconductor device according to example 1 of one embodiment of present technology
2. Semiconductor device according to example 2 of one embodiment of present technology
3. Semiconductor device according to example 3 of one embodiment of present technology
4. Semiconductor device according to example 4 of one embodiment of present technology
5. Semiconductor device according to example 5 of one embodiment of present technology
6. Semiconductor device according to example 6 of one embodiment of present technology
7. Semiconductor device according to example 7 of one embodiment of present technology
8. Semiconductor device according to example 8 of one embodiment of present technology
9. Semiconductor device according to example 9 of one embodiment of present technology
10. Semiconductor device according to example 10 of one embodiment of present technology
11. Semiconductor device according to example 11 of one embodiment of present technology
12. Modifications of present technology
13. Use example of solid-state imaging device to which present technology is applied
14. Different use example of solid-state imaging device to which present technology is applied
15. Example of application to mobile body
16. Example of application to endoscopic surgery system

### <0. Introduction>

Higher performance of a semiconductor device has conventionally been achieved by increasing integration of transistors and wires realized by segmentalization of manufacturing process. However, advancement of this segmentalization has caused such problems as a slower pace of performance improvement resulting from side effects of a parasitic element or the like and a rise of development and manufacturing costs.

Accordingly, for promoting development realizing higher integration and higher performance of a semiconductor device, chips having different functions have been manufactured by processes optimal for each chip and three-dimensionally laminated in recent years. For example, PTL 1 proposes such a method which laminates chips having different areas in such a manner that RDL (Redistribution Layer) wires face each other and which electrically connects the chips to the outside by using a via (through electrode) penetrating the small chip or the large chip.

According to the method which draws an external connection wire from the small chip side in PTL 1, however, integration of elements (e.g., transistors) within the small chip is lowered by the presence of the via (through electrode) penetrating the small chip. Moreover, in a case where the small chip is required to have a large thickness to obtain sufficient mechanical strength, the external connection wire needs to have a large diameter in view of the manufacturing difficulty. Accordingly, there is a problem of a trade-off relation between mechanical strength and integration.

In consideration of the abovementioned problems, the inventor has thus developed the semiconductor device of the present technology, which is a semiconductor device including a lamination of chips having different sizes, through improvement of a layout of wires (external connection wires) for connecting the chips and the outside.

One embodiment of the present technology will hereinafter be described in detail with several examples presented.

### <1. Semiconductor device according to example 1 of one embodiment of present technology>

### <<Configuration of semiconductor device>>

FIG. 1 is a cross-sectional diagram of a semiconductor device 10 according to example 1 of one embodiment of the present technology. FIG. 2 is a cross-sectional diagram taken along line A-A in FIG. 1. In the following description, it is assumed that the upper side in the cross-sectional diagrams such as FIG. 1 corresponds to "up" and that the lower side corresponds to "down."

As depicted in FIG. 1, the semiconductor device 10 includes at least one first element chip 100 (e.g., one first element chip 100), and at least one chip laminated on the first element chip 100 and smaller than the first element chip 100. The at least one chip includes at least one second element chip 200 (e.g., a plurality of second element chips 200). The "element chip" here refers to a chip where elements are provided. A direction where the first element chip 100 and the chip are laminated (up-down direction) will hereinafter also be referred to as a "lamination direction."

The first element chip 100 in one example is a chip such as a pixel chip, a logic chip, a memory chip, an AI chip, and an interface chip. For example, the first element chip 100 has a thickness in a range of 3 to 300µm. The first element chip 100 in one example presented here is a pixel chip. Note that an interface chip is an element chip configured to input and output signals. An AI (artificial intelligence) chip is an element chip having a learning function using AI.

For example, the pixel chip presented as one example of the first element chip 100 includes a plurality of pixels two-dimensionally arranged (for example, arranged in a matrix form). Each of the pixels has a photoelectric conversion element. For example, this photoelectric conversion element is a PD (photodiode). More specifically, for example, this photoelectric conversion element is a PN photodiode, a PIN photodiode, a SPAD (Single Photon Avalanche Photodiode), or an APD (avalanche photo Diode).

Each of the pixels in one example is a back-illuminated pixel to which light is applied from a rear surface of a first semiconductor substrate 100a (a surface opposite to a first wiring layer 100b). A region where a plurality of pixels are arranged in the first semiconductor substrate 100a will hereinafter also be referred to as a "pixel region."

The first semiconductor substrate 100a in one example includes the plurality of pixels described above, a control circuit (analog circuit) for controlling the respective pixels, and an A/D conversion circuit (with analog circuit).

For example, the control circuit includes circuit elements such as transistors. Specifically, the control circuit in one example includes a plurality of pixel transistors (what are generally called MOS transistors). For example, the plurality of pixel transistors may include three transistors including a transfer transistor, a reset transistor, and an amplification transistor. Alternatively, a selection transistor may be added to the plurality of pixel transistors to constitute four transistors. An equivalent circuit of a unit pixel is similar to an ordinary circuit. Accordingly, detailed description is not given in this point. Each of the pixels may be provided as one unit pixel. Alternatively, each of the pixels may have a shared pixel structure. This pixel shared structure is a structure where a plurality of photodiodes share a floating diffusion constituting a transfer transistor and a transistor other than the transfer transistor.

The A/D conversion circuit converts an analog signal generated by each of the pixels of the pixel chip into a digital signal.

Each of the second element chips 200 in one example is a chip such as a logic chip, a memory chip, an analog chip, an AI chip, and an interface chip. The plurality of second element chips 200 may include chips having the same function or chips having different functions. According to one example here, one of the second element chips 200 is a logic chip having a logic circuit, while a different one of the second element chips 200 is a memory chip having a memory circuit.

The logic circuit processes a digital signal generated by the A/D conversion circuit. The memory circuit temporarily stores and retains a digital signal generated by the A/D conversion circuit and/or a digital signal processed by the logic circuit.

For example, each of the second element chips 200 has a thickness in a range of 2 to 100 µm. The plurality of second element chips 200 may have either the same size and/or thickness or different sizes and/or thicknesses.

The first element chip 100 has a laminated structure where the first semiconductor substrate 100a and the first wiring layer 100b are laminated. Each of the second element chips 200 has a laminated structure where a second semiconductor substrate 200a and a second wiring layer 200b are laminated. The first wiring layer 100b and the second wiring layer 200b are joined face-to-face with each other.

For example, the first semiconductor substrate 100a is an Si substrate, a Ge substrate, a GaAs substrate, or an InGaAs substrate.

For example, the first wiring layer 100b may be manufactured in a pre-step of a semiconductor manufacturing process or may be rewiring (RDL). The first wiring layer 100b includes an insulation layer 100b1 and internal wires 100b2 (in-layer wires) provided within the insulation layer 100b1. The first wiring layer 100b may be either a single-layer wiring layer where the internal wires 100b2 are provided in a single layer within the insulation layer 100b1 or a multilayer wiring layer where the internal wires 100b2 are provided in multiple layers within the insulation film 100b1. For example, the insulation layer 100b1 includes a silicon oxide film or a silicon nitride film. For example, each of the internal wires 100b2 includes copper (Cu), aluminum (Al), or tungsten (W).

For example, the second semiconductor substrate 200a is an Si substrate, a Ge substrate, a GaAs substrate, or an InGaAs substrate.

For example, the second wiring layer 200b may be manufactured in a pre-step of a semiconductor manufacturing process or may be rewiring (RDL). The second wiring layer 200b includes an insulation layer 200b1 and internal wires 200b2 (in-layer wires) provided within the insulation layer 200b1. The second wiring layer 200b may be either a single-layer wiring layer where the internal wires 200b2 are provided in a single layer within the insulation layer 200b1 or a multilayer wiring layer where the internal wires 200b2 are provided in multiple layers within the insulation film 200b1. For example, the insulation layer 200b1 includes a silicon oxide film or a silicon nitride film. For example, each of the internal wires 200b2 includes copper (Cu), aluminum (Al), or tungsten (W).

The semiconductor device 10 further includes external connection terminals 700 each disposed at a position farther from the first element chip 100 in the lamination direction than a rear surface of the second element chip 200, which is a surface opposite to the first element chip 100 side. For example, each of the external connection terminals 700 has a form of a solder bump or a conductive film pillar.

The semiconductor device 10 further includes wires 400 each constituting external connection wires for electrically connecting the first wiring layer 100a and the external connection terminals 700.

As depicted in FIG. 2, a plurality of wires 400 are provided with a space left between each other along an outer circumferential surface of the corresponding second element chip 200 (e.g., semiconductor substrate 200a). A plurality of external connection terminals 700 are also provided in correspondence with the plurality of wires 400. Each of the external connection terminals 700 in one example is provided at such a position that at least a part (e.g., the whole) of the external connection terminal 700 overlaps with the corresponding second element chip 200 in a planar view.

Described with reference to FIG. 1 again, at least a part (e.g., the whole) of each of the wires 400 in one example is provided around the corresponding second element chip 200. Each of the wires 400 in one example is provided on at least a side surface of the corresponding second element chip 200 via an insulation film 300.

The insulation film 300 in one example covers the side surface and the rear surface of the corresponding second element chip 200. The insulation film 300 further covers portions of the first wiring layer 100b of the first element chip 100 around the second element chips 200.

For example, an inorganic film including SiO₂, SiON, SiN, SiOC, SiCN, or the like, or an organic film including resin containing silicone, polyimide, acryl, epoxy, or the like as a frame is available as the insulation film 300. For example, it is preferable that the insulation film 300 have a film thickness approximately in a range of 0.1 to 10 µm.

Each of the wires 400 in one example is configured such that one end is electrically connected to the first wiring layer 100b, and that the other end is electrically connected to the external connection terminal 700 on the insulation film 300 at a position farther from the first element chip 100 in the lamination direction than the rear surface of the corresponding second element chip 200 (e.g., a portion that is included in the insulation film 300 and covers the rear surface of the corresponding second element chip 200).

Each of the wires 400 in one example has a via portion 400a (vertical wire) and a wire portion 400b. The via portion 400a penetrates the insulation film 300. One end of the via portion 400a is connected to the corresponding wire 100b2 within the insulation layer 100b1. The wire portion 400b in one example has a crank shape which includes one vertical wire and two horizontal wires each extending along the first and second element chips 100 and 200. One end of the wire portion 400b is connected to the other end of the via portion 400a, while the other end of the wire portion 400b is connected to the external connection terminal 700. Here, the "vertical wire" refers to a wire extending in the lamination direction, while the "horizontal wire" refers to a wire extending in an in-plane direction (a direction perpendicular to the lamination direction).

For example, each of the wires 400 has a single layer structure or a multilayer structure including at least one type selected from Cu, Ti, Ta, Al, W, Ni, Ru, and Co. For example, it is preferable that each of the wires 400 have a thickness approximately in a range of 0.3 to 10 µm and a width approximately in a range of 1 to 40 µm.

The semiconductor device 10 further includes a filling film 500 provided near the side surface of each of the plurality of element chips 200 and near the rear surface of each of the element chips 200. The filling film 500 in one example is flattened. The filling film 500 in one example fills a part (specifically, a proximal end portion) of each of the external connection terminals 700.

For example, the filling film 500 includes an inorganic film including SiO₂, SiON, SiN, SiOC, SiCN, or the like, or an organic film including resin containing silicone, polyimide, acryl, epoxy, or the like as a frame, or a mold material containing fillers.

The semiconductor device 10 further includes a protection film 600 covering the filling film 500. The protection film 600 exposes the distal end portions of the external connection terminals 700. Specifically, the external connection terminals 700 project downward from the inside of the protection film 600.

The protection film 600 may include a material either identical to or different from a material of the filling film 500. Note that the protection film 600 may be eliminated. In this case, the filling film 500 may be so provided as to cover a part of the external connection terminals 700 on the rear surface side of the element chips 200 and expose the remaining part of the external connection terminals 700.

### <<Operation of semiconductor device>>

An operation of the semiconductor device 10 will hereinafter be described.

When light from a subject (image light) enters a photoelectric conversion element of each pixel, this photoelectric conversion element performs photoelectric conversion. An electric signal (analog signal) generated by photoelectric conversion at the photoelectric conversion element is transferred to an A/D conversion circuit and converted into a digital signal, then temporarily stored and retained by a memory circuit, and sequentially transferred to a logic circuit. The logic circuit processes the transferred digital signal. Note that the digital signal may be temporarily stored and retained in the memory circuit during and/or after the processing at the logic circuit.

### <<Manufacturing method of semiconductor device>>

A manufacturing method of the semiconductor device 10 will hereinafter be described with reference to a flowchart in FIG. 3 and FIG. 4A to FIG. 8B.

In first step S1, the first element chip 100 and a plurality of second element chips 200 are prepared (see FIG. 4A and FIG. 4B). Specifically, for forming the first element chip 100, elements are formed on the first semiconductor substrate 100a by photolithography, and the first wiring layer 100b is formed on the first semiconductor substrate 100a. For forming the plurality of second element chips 200, elements are formed for each chip on a wafer constituting the second semiconductor substrates 200a by photolithography, and a wiring film constituting the second wiring layer 200b is formed on the wafer. Thereafter, the wafer is divided for each chip by dicing.

In subsequent step S2, the first element chip 100 and the plurality of second element chips 200 are joined to each other (see FIG. 4C). Specifically, the first wiring layer 100b of the first element chip 100 and the second wiring layers 200b of the second element chips 200 are directly joined face-to-face with each other by metal junction or other methods.

In subsequent step S3, the insulation film 300 is formed (see FIG. 4D). Specifically, the insulation film 300 is formed by PE-CVD (Plasma-Enhanced chemical vapor deposition) or ALD (Atomic Layer Deposition).

In subsequent step S4, first contact holes CH1 are formed (see FIG. 5A). Specifically, the insulation film 300 and the insulation film 100b1 of the first wiring layer 100b are opened by photolithography and plasma etching to form the first contact holes CH1. As a result, the internal wires 100b2 of the first wiring layer 100b are exposed through the first contact holes CH1.

In subsequent step S5, the wires 400 are formed. Specifically, the wires 400 are formed by what is generally called a semi-additive process. First, a Ti film is formed as a barrier metal film by PE-PVD, and then a Cu film is formed as a seed metal film on this Ti film to form a metal film MF (see FIG. 5B). Subsequently, a resist pattern R covering portions where the wires 400 are not provided is formed by photolithography (see FIG. 5C). Thereafter, electric field plating is carried out using the resist pattern R as a mask, to form metal plating MP (e.g., Cu plating) (see FIG. 6A). Then, the resist is removed (see FIG. 6B), and the metal film MF covering the portions where the wires 400 are not provided is removed by wet etching (see FIG. 6C). As a result, the wires 400 including metal plating MP are formed.

In subsequent step S6, the filling film 500 is formed and flattened (see FIG. 7A). Specifically, the filling film 500 is formed by PE-CVD. Thereafter, the filling film 500 is polished and flattened by a grinder, a CMP device, or the like.

In subsequent step S7, second contact holes CH2 are formed (see FIG. 7B). Specifically, the filling film 500 is opened by photolithography and dry etching to form the second contact holes CH2. As a result, the wires 400 are exposed through the second contact holes CH2.

In subsequent step S8, the protection film 600 is formed (see FIG. 7C). Specifically, a film including a photosensitive resin material is formed as the protection film 600, for example.

In subsequent step S9, third contact holes CH3 are formed (see FIG. 8A). Specifically, portions that are included in the protection film 600 and that correspond to the second contact holes CH2 are opened by patterning using photolithography, to form the third contact holes CH3. As a result, the wires 400 are exposed through the second and third contact holes CH2 and CH3.

In final step S10, the external connection terminals 700 are formed (see FIG. 8B). Specifically, the external connection terminals 700 (e.g., solder balls) are formed by ball mounting at the second and third contact holes CH2 and CH3 in such a manner as to be connectable with the wires 400.

### <<Advantageous effects of semiconductor device and manufacturing method of semiconductor device>>

Advantageous effects of the semiconductor device 10 according to example 1 of one embodiment of the present technology will hereinafter be described.

The semiconductor device 10 according to example 1 includes at least one first element chip 100 and a plurality of (e.g., two) second element chips 200 laminated with the first element chip 100 and smaller than the first element chip 100. The first element chip 100 has a laminated structure where the first semiconductor substrate 100a and the first wiring layer 100b are laminated. Each of the second element chips 200 has a laminated structure where the second semiconductor substrate 200a and the second wiring layer 200b are laminated. The first wiring layer 100b and the second wiring layer 200b are joined face-to-face with each other. The semiconductor device 10 further includes the external connection terminals 700 each disposed at a position farther from the first element chip 100 in the lamination direction than the rear surface of the corresponding second element chip 200. The rear surface is a surface on the side opposite to the first element chip 100. The semiconductor device 10 further includes the wires 400 each of which has at least a part disposed around the second element chips 200 and electrically connects the first wiring layer 100b and the corresponding external connection terminal 700.

According to the semiconductor device 10, the wires 400 constituting external connection wires do not penetrate the second element chips 200. Accordingly, a sufficient element providing space can be produced within each of the second element chips 200.

According to the semiconductor device provided as the semiconductor device 10, integration of elements within the second element chips 200 improves.

Moreover, according to the semiconductor device 10, even when each of the wires 400 as the external connection wires has a large diameter in view of the manufacturing difficulty in a case where each of the second element chips 200 is required to have a large thickness to obtain sufficient mechanical strength, for example, integration of the elements within the second element chips 200 improves.

Furthermore, according to the semiconductor device 10, each of the second element chips 200 is not required to have a through hole. Accordingly, the second element chips 200 is manufacturable in an easy manner. This advantageous effect increases as each of the second element chips 200 has a larger thickness.

The wires 400 may be provided on at least the side surface of each of the second element chips 200 via the insulation film 300. This configuration can provide the wires 400 along the side surfaces of the second element chips 200 while insulating the wires 400 from the second element chips 200.

The insulation film 300 covers the side surface and the rear surface of each of the second element chips 200. Each of the wires 400 is configured such that one end is electrically connected to the first wiring layer 100b, and that the other end is electrically connected to the corresponding external connection terminal 700 at a position farther from the first element chip 100 in the lamination direction than the rear surface of the corresponding second element chip 200. This configuration can electrically connect the first wiring layer 100b and the external connection terminals 700 by a simple wiring structure.

The semiconductor device 10 further includes the filling film 500 provided near the side surface and the rear surface of each of the plurality of element chips 200. This configuration can fill peripheries of the respective second element chips 200, and can thus protect the first and second element chips 100 and 200.

It is preferable that the filling film 500 be flattened. This configuration facilitates junction between the surface of the semiconductor device 10 on the filling film 500 side and the outside (e.g., a circuit board).

The semiconductor device 10 further includes the protection film 600 which covers the filling film 500 and which exposes the distal end portions of the external connection terminals 700. This configuration can make electric connection with the outside (e.g., a circuit board) while sufficiently protecting the first and second element chips 100 and 200.

The manufacturing method of the semiconductor device 10 according to example 1 includes a step of joining the first wiring layer 100b of a first lamination stack that includes the first semiconductor substrate 100a and the first wiring layer 100b laminated together and the second wiring layer 200b of a second lamination stack that is smaller than the first lamination stack and includes the second semiconductor substrate 200a and the second wiring layer 200b laminated together, in such a manner that the first wiring layer 100b and the second wiring layer 200b face each other, a step of forming the insulation film 300 from the second lamination stack side, a step of etching the insulation film 300 and the first wiring layer 100b around the second lamination stack to expose the internal wire 100b2 of the first wiring layer 100b, and a step of forming the wire 400 that is disposed at least near a side surface of the second lamination stack and is connected to the internal wire 100b2.

According to the manufacturing method of the semiconductor device 10, the semiconductor device 10 capable of improving integration of elements within the second element chips 200 can be manufactured.

The manufacturing method of the semiconductor device 10 further includes a step of forming the filling film 500 from the second lamination stack on the side opposite to the first lamination stack, and a step of polishing and flattening the filling film 500. This configuration facilitates junction between the surface of the semiconductor device 10 on the filling film 500 side and the outside (e.g., a circuit board).

### <2. Semiconductor device according to example 2 of one embodiment of present technology>

FIG. 9 is a cross-sectional diagram of a semiconductor device 20 according to example 2 of one embodiment of the present technology. As depicted in FIG. 9, the semiconductor device 20 according to example 2 has a configuration similar to that of the semiconductor device 10 according to example 1 except that each of second element chips 200B has a substantially tapered vertical cross section having a width which decreases with farness from the first element chip 100.

Each of the second semiconductor substrate 200a1 and the second wiring layer 200b1 included in each of the second element chips 200B has a substantially tapered vertical cross section. Accordingly, each of the second element chips 200B has a substantially tapered vertical cross section on the whole.

A corner at each of an uppermost portion (a portion closest to the first element chip 100) and/or a lowermost portion (a portion farthest from the first element chip 100) of each of the second element chips 200B may be rounded.

The substantially tapered shape of each of the second element chips 200B may be formed by dry etching or dicing, for example.

According to the semiconductor device 20, each of the second element chips 200B has a substantially tapered vertical cross section. In this case, a lithography step for forming the wires 400 on the side surface side of the second element chips 200B is facilitated (particularly exposure is facilitated). Accordingly, integration and yields of the wires 400 are expected to improve. Moreover, sufficient coverage for forming the insulation film 300 is easily achievable. Accordingly, deterioration of insulation and reliability caused by thickness reduction of the insulation film 300 can be reduced particularly at the uppermost corners of the second element chips 200B. Further, concentration of an electric field on the insulation film 300 is avoidable by the rounded corners of the second element chips 200B. Accordingly, reliability further improves.

### <3. Semiconductor device according to example 3 of one embodiment of present technology>

FIG. 10 is a cross-sectional diagram of a semiconductor device 30 according to example 3 of one embodiment of the present technology. As depicted in FIG. 10, the semiconductor device 30 according to example 3 has a configuration similar to that of the semiconductor device 10 according to example 1 except that at least one chip includes at least one (e.g., one) dummy chip 200C (a chip having no element) in addition to the second element chips 200.

The dummy chip 200C has a structure similar to that of the second element chips 200 except that no element is formed on the second semiconductor substrate 200a and that the internal wires 200b2 are not formed within the insulation layer 200b1. The tummy chip 200C includes the wires 400 similarly to the second element chips 200.

According to the semiconductor device 30, the dummy chip 200C (a portion where the second element chips 200 are not disposed) also has the wires 400. Accordingly, the degree of freedom in design improves.

### <4. Semiconductor device according to example 4 of one embodiment of present technology>

FIG. 11 is a cross-sectional diagram of a semiconductor device 40 according to example 4 of one embodiment of the present technology. As depicted in FIG. 11, the semiconductor device 40 according to example 4 has a configuration similar to that of the semiconductor device 10 according to example 1 except that some of the plurality of external connection terminals 700 are provided at portions not overlapping with at least the second element chips 200 in a planar view. Note that all of the plurality of external connection terminals 700 may be provided at portions not overlapping with at least the second element chips 200 in the planar view. Note that the plurality of external connection terminals 700 may include the external connection terminal 700 a part of which overlaps with (the remaining part of which does not overlap with) the second element chip or the dummy chip in the planar view.

According to the semiconductor device 40, each of wires 400D includes, in addition to the via portion 400a and the wire portion 400b, a via portion 400c which penetrates the filling film 500 near the second element chip 200 on the side (rear surface side) opposite to the first element chip 100 and has one end connected to one end of the wire portion 400b, and a horizontal wire portion 400d which extends in the in-plane direction within the protection film 600 and has one end connected to the other end of the via portion 400c. The other end of the horizontal wire portion 400d is connected to the corresponding external connection terminal 700 within the protection film 600. Each of the external connection terminals 700 projects downward from the inside of the protection film 600 to have an exposed distal end.

The semiconductor device 40 can be manufactured by a method similar to the manufacturing method of the semiconductor device 10 of example 1 except that a step of forming the via portions 400c and the horizontal wire portions 400d is added.

According to the semiconductor device 40, the external connection terminals 700 can also be disposed at portions not overlapping with the second element chips 200 in the planar view. This configuration is advantageous in terms of high integration of external connection wires and external connection terminals.

### <5. Semiconductor device according to example 5 of one embodiment of present technology>

### <<Configuration of semiconductor device>>

FIG. 12 is a cross-sectional diagram of a semiconductor device 50 according to example 5 of one embodiment of the present technology. As depicted in FIG. 12, the semiconductor device 50 according to example 5 has a configuration substantially similar to that of the semiconductor device 10 according to example 1 except that the insulation film 300 is provided only on the side surface side of each of the second element chips 200 and that a protection film 550 is further provided on each of the rear surfaces of the second element chips 200. The protection film 550 may include either a material identical to the materials of the insulation film 300 and the filling film 500, or a material (dielectric material) different from these materials.

According to the semiconductor device 50, each of wires 400E includes, in addition to the via portion 400a, the wire portion 400b (a wire portion including a vertical wire and a horizontal wire) which has a substantially L-shaped cross section and has one end connected to the via portion 400a, and the horizontal wire portion 400c which has one end connected to the other end of the wire portion 400b and extends in the horizontal direction within the protection film 600. The other end of the horizontal wire portion 400c is connected to the corresponding external connection terminal 700 within the protection film 600. Each of the external connection terminals 700 projects downward from the inside of the protection film 600 to have an exposed distal end. Hereinafter, the via portion 400 and the wire portion 400b will also be collectively referred to as a "first wire," and the horizontal wire portion 400c will also be referred to as a "second wire." According to the semiconductor device 50 in one example, some of the external connection terminals 700 are disposed at positions overlapping with the second element chips 200, and the other external connection terminals 700 are disposed at positions not overlapping with the second element chips 200 in a planar view.

According to the semiconductor device 50, the insulation film 300 is not provided near each of the second element chips 200 on the side opposite to the first element chip 100.

### <<Manufacturing method of semiconductor device>>

A manufacturing method of the semiconductor device 50 will hereinafter be described with reference to a flowchart in FIG. 13, FIG. 14A to FIG. 15D, and the like.

In first step S21, the first element chip 100 and chip base materials 200m constituting the respective second element chips 200 are prepared. Each of the chip base materials 200m has a laminated structure where the second semiconductor substrate 200a and the second wiring layer 200b are laminated. The chip base materials 200m have thicknesses (e.g., thicknesses of the second semiconductor substrates 200a) different from each other. For forming the first element chip 100, elements are formed on the first semiconductor substrate 100a by photolithography, and the first wiring layer 100b is formed on the first semiconductor substrate 100a. For forming the chip base material 200m having a larger thickness, elements are formed on the second semiconductor substrate 200a having a larger thickness by photolithography, and the second wiring layer 200b is formed on the second semiconductor substrate 200a thus formed. For forming the chip base material 200m having a smaller thickness, elements are formed on the second semiconductor substrate 200a having a smaller thickness by photolithography, and the second wiring layer 200b is formed on the second semiconductor substrate 200a thus formed.

In subsequent step S22, the first element chip 100 and a plurality of chip base materials 200m are joined to each other (see FIG. 4C). Specifically, the first wiring layer 100b of the first element chip 100 and the second wiring layers 200b of the chip base materials 200m are directly joined face-to-face with each other by metal junction or other methods.

In subsequent step S23, the insulation film 300 is formed (see FIG. 4D). Specifically, the insulation film 300 is formed by PE-CVD (Plasma-Enhanced chemical vapor deposition) or ALD (Atomic Layer Deposition).

In subsequent step S24, the first contact holes CH1 are formed (see FIG. 5A). Specifically, the insulation film 300 and the insulation film 100b1 of the first wiring layer 100b are opened by photolithography and plasma etching to form the first contact holes CH1. As a result, the wires 100b2 of the first wiring layer 100b are exposed through the first contact holes CH1.

In subsequent step S25, the first wires are formed (see FIG. 5B). Specifically, the first wires (via portions 400a and wire portions 400b) are formed by what is generally called a semi-additive process. First, a Ti film is formed as a barrier metal film by PE-PVD, and then a Cu film is formed as a seed metal film on this Ti film to form the metal film MF. Subsequently, the resist pattern R covering portions where the first wires are not provided is formed by photolithography (see FIG. 5C). Thereafter, electric field plating is carried out using the resist pattern R as a mask, to form metal plating MP1 (e.g., Cu plating) (see FIG. 6A). Then, the resist is removed (see FIG. 6B), and the metal film MF covering the portions where the first wires are not provided is removed by wet etching (see FIG. 6C). As a result, the first wires including the metal plating MP1 are formed.

In subsequent step S26, the filling film 500 is formed (see FIG. 14A). Specifically, the filling film 500 is formed by PE-CVD, for example.

In subsequent step S27, a flat surface through which the first wires, the insulation film 300, and the second semiconductor substrates 200b are exposed is formed (see FIG. 14B). Specifically, the filling film 500 and the plurality of second semiconductor substrates 200a (portions not including elements) having different thicknesses are ground and polished by a grinder, a CMP device, or the like to form the flat surface, for example. In this example, the plurality of second semiconductor substrates 200a are flattened together with the filling film 500. As a result, a plurality of second element chips 200 having the same thickness are formed.

In subsequent step S28, the protection film 550 is formed as the first protection film (see FIG. 14C). Specifically, the protection film 550 is formed by PE-CVD, for example.

In subsequent step S29, the second contact holes CH2 are formed (see FIG. 14D). Specifically, the protection film 550 is opened by photolithography and dry etching to form the second contact holes CH2. As a result, the first wires (metal plating MP1) are exposed through the second contact holes CH2.

In subsequent step S30, the second wires are formed (see FIG. 15A). Specifically, by using a semi-additive process as in the case of the first wires, metal plating MP2 that constitutes the second wires and that is connected to the metal plating MP1 constituting a part of the first wires is formed at positions overlapping with the second element chips 200, and the metal plating MP2 that constitutes the second wires and that is connected to the metal plating MP1 constituting the remaining first wires is formed at positions not overlapping with the second element chips 200.

In subsequent step S31, a second protection film is formed (see FIG. 15B). Specifically, the protection film 600 including a photosensitive resin material, for example, is formed as the second protection film.

In subsequent step S32, the third contact holes CH3 are formed (see FIG. 15C). Specifically, portions that are included in the protection film 600 and that correspond to the metal plating MP2 constituting the second wires are opened by patterning using photolithography, to form the third contact holes CH3. As a result, the metal plating MP2 is exposed through the third contact holes CH3.

In final step S33, the external connection terminals 700 are formed (see FIG. 15D). Specifically, the external connection terminals 700 (e.g., solder balls) are formed by ball mounting at the third contact holes CH3 in such a manner as to be connectable with the metal plating MP2.

### <<Advantageous effects of semiconductor device>>

The semiconductor device 50 providable according to example 5 has a structure similar to that of the semiconductor device 10 of example 1 even with use of the chip base materials 200m constituting the respective second element chips 200 and having different thicknesses. Accordingly, the semiconductor device 50 has a high degree of freedom in selection of the chip base materials 200m forming the second element chips 200.

### <6. Semiconductor device according to example 6 of one embodiment of present technology>

### <<Configuration of semiconductor device>>

FIG. 16 is a cross-sectional diagram of a semiconductor device 60 according to example 6 of one embodiment of the present technology. As depicted in FIG. 16, the semiconductor device 60 according to example 6 has a configuration substantially similar to that of the semiconductor device 10 according to example 1 except that each of pixels in a pixel region of a pixel chip constituting the first element chip 100 has a color filter 910 and a micro-lens 920 (on-chip lens). The pixel region may include an anti-reflection film. The first semiconductor device 100a has a reduced thickness approximately in a range of 3 to 30 µm.

The semiconductor device 60 further includes a transparent substrate 940 joined via an adhesive layer 930 to a surface included in the pixel chip 100 and located near a plurality of micro-lenses 920. The adhesive layer 930 may be provided on only a region around the pixel region rather than on the entire surface, for example.

### <<Manufacturing method of semiconductor device>>

A manufacturing method of the semiconductor device 60 will hereinafter be described with reference to a flowchart in FIG. 17, FIG. 18A to FIG. 20C, and the like.

In first step S41, the first element chip 100 and a plurality of second element chips 200 are prepared (see FIGS. 4A and B). Specifically, for forming the first element chip 100, elements are formed on the first semiconductor substrate 100a by photolithography, and the first wiring layer 100b is formed on the first semiconductor substrate 100a. For forming the plurality of second element chips 200, elements are formed for each chip on a wafer constituting the second semiconductor substrates 200a by photolithography, and a wiring film constituting the second wiring layer 200b is formed on the wafer. Thereafter, the wafer is divided for each chip by dicing.

In subsequent step S42, the first element chip 100 and the plurality of second element chips 200 are joined to each other (see FIG. 4C). Specifically, the first wiring layer 100b of the first element chip 100 and the second wiring layers 200b of the second element chips 200 are directly joined face-to-face with each other by metal junction or other methods.

In subsequent step S43, the insulation film 300 is formed (see FIG. 4D). Specifically, the insulation film 300 is formed by PE-CVD (Plasma-Enhanced chemical vapor deposition) or ALD (Atomic Layer Deposition).

In subsequent step S44, the first contact holes CH1 are formed (see FIG. 5A). Specifically, the insulation film 300 and the insulation film 100b1 of the first wiring layer 100b are opened by photolithography and plasma etching to form the first contact holes CH1. As a result, the wires 100b2 of the first wiring layer 100b are exposed through the first contact holes CH1.

In subsequent step S45, the wires 400 are formed. Specifically, the wires 400 are formed by what is generally called a semi-additive process. First, a Ti film is formed as a barrier metal film by PE-PVD, and then a Cu film is formed as a seed metal film on this Ti film to form the metal film MF (see FIG. 5B). Subsequently, the resist pattern R covering portions where the wires 400 are not provided is formed by photolithography (see FIG. 5C). Thereafter, electric field plating is carried out using the resist pattern R as a mask, to form the metal plating MP (e.g., Cu plating) (see FIG. 6A). Then, the resist is removed (see FIG. 6B), and the metal film MF covering the portions where the wires 400 are not provided is removed by wet etching (see FIG. 6C). As a result, the wires 400 are formed.

In subsequent step S46, the filling film 500 is formed and flattened (see FIG. 7A). Specifically, the filling film 500 is formed by PE-CVD. Thereafter, the filling film 500 is flattened by a grinder, a CMP device, or the like.

In subsequent step S47, a support substrate SB is joined by an adhesive G (see FIG. 18A).

In subsequent step S48, the thickness of the first element chip 100 is reduced (see FIG. 18B). Specifically, the rear surface (upper surface) of the first semiconductor substrate 100a of the first element chip 100 is ground and polished by a grinder, a CMP device, or the like, for example, to reduce the thickness of the first element chip 100 to 10 µm, for example.

In subsequent step S49, an anti-reflection film, the color filters 910, and the micro-lenses 920 are formed (see FIG. 18C).

In subsequent step S50, the transparent substrate 940 is joined to the first element chip 100 via the adhesive layer 930 (see FIG. 19A).

In subsequent step S51, the support substrate SB and the adhesive G are removed (see FIG. 19B).

In subsequent step S52, the second contact holes CH2 are formed (see FIG. 19C). Specifically, the filling film 500 is opened by photolithography and dry etching to form the second contact holes CH2. As a result, the wires 400 (metal plating MP) are exposed through the second contact holes CH2.

In subsequent step S53, the protection film 600 is formed (see FIG. 20A). Specifically, a film including a photosensitive resin material is formed as the protection film 600, for example.

In subsequent step S54, the third contact holes CH3 are formed (see FIG. 20B). Specifically, portions that are included in the protection film 600 and that correspond to the second contact holes CH2 are opened by photolithography and dry etching to form the third contact holes CH3. As a result, some parts of the wires 400 (metal plating MP) are exposed through the second and third contact holes CH2 and CH3.

In final step S55, the external connection terminals 700 are formed (see FIG. 20C). Specifically, the external connection terminals 700 (e.g., solder balls) are formed by ball mounting at the second and third contact holes CH2 and CH3 in such a manner as to be connectable with the wires 400 (metal plating MP).

### <<Advantageous effects of semiconductor device>>

According to the semiconductor device 60, junction between the chips and formation of the insulation film 300, the wires 400, and the filling film 500 are achievable before formation of the color filters and the on-chip lenses requiring a limited processing temperature. Accordingly, a higher quality and more reliable semiconductor device is providable. Moreover, in a case where the first element chip 100 is a pixel chip, the thickness of the first element chip 100 is required to be reduced to a thickness of 30 µm or smaller, for example. In this case, each of the second element chips 200 needs to have a larger thickness to obtain sufficient mechanical strength. Hence, the layout of the external connection wires of the present technology is extremely advantageous.

### <7. Semiconductor device according to example 7 of one embodiment of present technology>

### <<Configuration of semiconductor device>>

FIG. 21 is a cross-sectional diagram of a semiconductor device 70 according to example 7 of one embodiment of the present technology. As depicted in FIG. 21, the semiconductor device 70 according to example 7 includes a support substrate 560 joined to the second element chips 200 via an insulation layer containing the filling film 500 and the protection film 550. The external connection terminals 700 are provided on the side opposite to the insulation layer side of the support substrate 560.

The support substrate 560 in one example has a size substantially identical to the size of the first element chip 100. The support substrate 560 in one example is a semiconductor substrate (e.g., a silicon substrate).

The insulation layer containing the filling film 500 and the protection film 550 is provided on the side surface side of the second element chips 200 and the rear surface side of the second element chips 200.

Each of wires 400G includes a first through electrode 400a1 (vertical wire) penetrating the insulation layer on the side surface side of the second element chip 200, a second through electrode 400c1 (vertical wire) penetrating the support substrate 560, and a horizontal wire 400b1 disposed within the insulation layer and electrically connected to the first and second through electrodes 400a1 and 400c1.

The first through electrode 400a1 penetrates the filling film 500 of the insulation layer in the lamination direction and has one end connected to the corresponding internal wire 100b2 of the first wiring layer 100b. The horizontal wire 400b1 extends in the in-plane direction within the protection film 550 of the insulation layer and has one end connected to the other end of the first through electrode 400a1. The second through electrode 400c1 penetrates the support substrate 560 in the lamination direction and has one end connected to the other end of the horizontal wire 400b1 within the protection film 550 and the other end connected to the corresponding external connection terminal 700 within the protection film 600. An insulation film 570 is provided between the support substrate 560 and the second through electrode 400c1 and between the support substrate 560 and the protection film 600. The insulation film 570 may include either a material identical to the material of the protection film 600 or a material (dielectric material) different from this material.

According to the semiconductor device 70, it is preferable that the first element chip 100 have a thickness approximately in a range of 3 to 100 µm, and that each of the second element chips 200 have a thickness approximately in a range of 2 to 50 µm. The semiconductor device 70 is particularly effective in a case where each of the second element chips 200 has a smaller thickness than that in example 1. It is preferable that the support substrate 560 have a thickness approximately in a range of 30 to 200 µm. It is preferable that each of the via portions 400a1 have a diameter approximately in a range of 0.1 to 10 µm. It is preferable that each of the through electrodes have a diameter approximately in a range of 3 to 60 µ and an aspect ratio of 10 or smaller.

### <<Manufacturing method of semiconductor device>>

A manufacturing method of the semiconductor device 70 will hereinafter be described with reference to a flowchart in FIG. 22, FIG. 23A to FIG. 26C, and the like.

In first step S61, the first element chip 100 and a plurality of second element chips 200 are prepared (see FIGS. 4A and 4B). Specifically, for forming the first element chip 100, elements are formed on the first semiconductor substrate 100a by photolithography, and the first wiring layer 100b is formed on the first semiconductor substrate 100a. For forming the plurality of second element chips 200, elements are formed for each chip on a wafer constituting the second semiconductor substrates 200a by photolithography, and a wiring film constituting the second wiring layer 200b is formed on the wafer. Thereafter, the wafer is divided for each chip by dicing.

In subsequent step S62, the first element chip 100 and the plurality of second element chips 200 are joined to each other (see FIG. 23A). Specifically, the first wiring layer 100b of the first element chip 100 and the second wiring layers 200b of the second element chips 200 are directly joined face-to-face with each other by metal junction or other methods.

In subsequent step S63, the filling film 500 is formed and flattened (see FIG. 23B). Specifically, the filling film 500 is formed by PE-CVD, and then the filling film 500 is flattened by grinding and polishing using a grinder, a CMP device, or the like.

In subsequent step S64, the first through holes TH1 are formed (see FIG. 23C). Specifically, the filling film 500 and the insulation film 100b1 of the first wiring layer 100b are opened by photolithography and plasma etching to form the first through holes TH1. As a result, the internal wires 100b2 of the first wiring layer 100b are exposed through the first through holes TH1.

In subsequent step S65, the first wires are formed (see FIG. 24A). Specifically, the first wires each including the first through electrode 400a1 and the horizontal wire 400b1 are formed by what is generally called a semi-additive process. First, a Ti film is formed as a barrier metal film by PE-PVD, and then a Cu film is formed as a seed metal film on this Ti film to form the metal film MF. Subsequently, the resist pattern R covering portions where the first wires are not provided is formed by photolithography. Thereafter, electric field plating is carried out with use of the resist pattern R as a mask, to form the metal plating MP1 (e.g., Cu plating). Then, the resist is removed, and the metal film MF covering the portions where the first wires are not provided is removed by wet etching. As a result, the first wires including the metal plating MP1 are formed. Note that each of the first through electrodes 400a1 and/or the horizontal wires 400b1 may be formed by damascening, for example.

In subsequent step S66, the protection film 550 as a first insulation film is formed and flattened (see FIG. 24B). Specifically, the insulation film 300 is formed by PE-CVD (Plasma-Enhanced chemical vapor deposition) or ALD (Atomic Layer Deposition), and flattened by grinding and polishing with use of a grinder, a CMP device, or the like, for example.

In subsequent step S67, the protection film 550 as the first insulation film is joined to the support substrate 560 (see FIG. 24C). Specifically, the support substrate 560 as a semiconductor substrate on a surface of which an oxide film is slightly formed is directly joined to the protection film 550. The support substrate 560 is affixed in a state of a wafer. At this time, the thickness of the first semiconductor substrate 100a of the first element chip 100 may be reduced by grinding and polishing as necessary.

In subsequent step S68, the second through holes TH2 are formed in the support substrate 560 (see FIG. 25A). Specifically, the second through holes TH2 are formed in the support substrate 560 by lithography or plasma etching.

In subsequent step S69, the second insulation film 570 is formed (see FIG. 25B). Specifically, the second insulation film 570 is formed by PE-CVD or ALD.

In subsequent step S70, first contact holes are formed. Specifically, the second insulation film 570 and the protection film 550 on bottom portions of the second through holes TH2 are opened by dry etching to form the first contact holes. As a result, the first wires (metal plating MP1) are exposed through the first contact holes.

In subsequent step S71, the second wires are formed (see FIG. 25C). Specifically, the metal plating MP2 which has the second through electrodes 400c1 within the first contact holes and the second through holes TH2 and has rear surface wires on the rear surface of the support substrate 560 around the second through holes TH2 to constitute the second wires is formed by what is generally called a semi-additive process.

In subsequent step S72, the protection film 600 is formed (see FIG. 26A). Specifically, a film including a photosensitive resin material is formed as the protection film 600, for example.

In subsequent step S73, the second contact holes CH2 are formed (see FIG. 26B). Specifically, the protection film 600 is opened by photolithography and dry etching to form the second contact holes CH2. As a result, some parts (rear surface wires) of the second wires (metal plating MP2) are exposed through the second contact holes CH2.

In final step S74, the external connection terminals 700 are formed (see FIG. 26C). Specifically, the external connection terminals 700 (e.g., solder balls) are formed by ball mounting at the second contact holes CH2 in such a manner as to be connectable with some parts (rear surface wires) of the second wires (metal plating MP2).

### <<Advantageous effects of semiconductor device>>

According to the semiconductor device 70, the external connection wires and the external connection terminals 700 are allowed to be disposed with a high degree of integration while sufficient mechanical strength of the support substrate 560 is obtained even in a case where each of the first and second element chips 100 and 200 has a small thickness, for example. Moreover, deterioration of yields and processing accuracy caused by a warp or the like can be reduced by the support substrate 560 even during manufacture.

The manufacturing method of the semiconductor device 70 includes a step of joining the first wiring layer 100b of a first lamination stack that includes the first semiconductor substrate 100a and the first wiring layer 100b laminated together and the second wiring layer 200b of a second lamination stack that is smaller than the first lamination stack and includes the second semiconductor substrate 200a and the second wiring layer 200b laminated together, in such a manner that the first wiring layer 100b and the second wiring layer 200b face each other, a step of forming the filling film 500 from the second lamination stack on the side opposite to the first lamination stack, a step of flattening the filling film 500, a step of etching the filling film 500 and the first wiring layer 100b around the second lamination stack to form the first through electrode 400a1 (via) that has one end connected to the internal wire 100b2 (in-layer wire) of the first wiring layer 100b, a step of forming the horizontal wire 400b1 that is disposed on the surface of the filling film 500 on the side opposite to the second lamination stack and is electrically connected to the other end of the first through electrode 400a1, a step of covering the horizontal wire 400b1 with the protection film 550, a step of arranging the support substrate 560 near the protection film 550 on the side opposite to the first lamination stack, and a step of forming the second through electrode 400c1 disposed on the support substrate 560 and connected to the horizontal wire 400b1.

### <8. Semiconductor device according to example 8 of one embodiment of present technology>

FIG. 27 is a cross-sectional diagram of a semiconductor device 80 according to example 8 of one embodiment of the present technology. As depicted in FIG. 27, the semiconductor device 80 according to example 8 has a configuration similar to that of the semiconductor device 70 according to example 7 except that the support substrate 560 is a semiconductor substrate and that a wiring layer 555 is disposed between the support substrate 560 and the insulation layer containing the filling film 500 and the protection film 550. For example, the semiconductor substrate constituting the support substrate 560 has elements including an analog circuit, a logic circuit, a memory circuit, an AI circuit, and an interface circuit. The wiring layer 555 has an insulation film and internal wires provided within the insulation film. The internal wires are electrically connected to the elements provided on the support substrate 560.

Each of the second through electrodes 400c1 in the semiconductor device 80 penetrates the support substrate 560 in the lamination direction and has one end connected to the horizontal wire 400b1 and the other end connected to the corresponding external connection terminal 700. Each of second through electrodes 400d1 in the semiconductor device 80 penetrates the support substrate 560 in the lamination direction and has one end connected to the corresponding internal wire of the wiring layer 555 and the other end connected to the corresponding external connection terminal 700.

According to the semiconductor device 80, the elements are provided on the semiconductor substrate constituting the support substrate 560. Accordingly, increased integration of the entire device is allowed. Note that the manufacturing method of the semiconductor device 80 is similar to the manufacturing method of the semiconductor device 70 except that a step of forming the wiring layer 555 on the protection film 550 is performed between the step of covering with the protection film 550 and the step of arranging the support substrate 560.

### <9. Semiconductor device according to example 9 of one embodiment of present technology>

### <<Configuration of semiconductor device>>

FIG. 28 is a cross-sectional diagram of a semiconductor device 90 according to example 9 of one embodiment of the present technology. As depicted in FIG. 28, the semiconductor device 60 according to example 9 has a configuration substantially similar to that of the semiconductor device 70 according to example 7 except that each of pixels in the pixel region of the pixel chip constituting the first element chip 100 has the color filter 910 and the micro-lens 920 (on-chip lens). For example, the pixel region may include an anti-reflection film. The first semiconductor device 100a has a reduced thickness approximately in a range of 3 to 30 µm.

The semiconductor device 60 further includes the transparent substrate 940 joined via the adhesive layer 930 to the surface included in the pixel chip 100 and located near a plurality of micro-lenses 920. The adhesive layer 930 may be provided only on a region around the pixel region rather than on the entire surface.

### <<Manufacturing method of semiconductor device>>

A manufacturing method of the semiconductor device 70 will hereinafter be described with reference to a flowchart in FIG. 29, FIG. 31A to FIG. 35B, and the like.

In first step S81, the first element chip 100 and a plurality of second element chips 200 are prepared (see FIGS. 4A and 4B). Specifically, for forming the first element chip 100, elements are formed on the first semiconductor substrate 100a by photolithography, and the first wiring layer 100b is formed on the first semiconductor substrate 100a. For forming the plurality of second element chips 200, elements are formed for each chip on a wafer constituting the second semiconductor substrates 200a by photolithography, and a wiring film constituting the second wiring layer 200b is formed on the wafer. Thereafter, the wafer is divided for each chip by dicing.

In subsequent step S82, the first element chip 100 and the plurality of second element chips 200 are joined to each other (see FIG. 23A). Specifically, the first wiring layer 100b of the first element chip 100 and the second wiring layers 200b of the second element chips 200 are directly joined face-to-face with each other by metal junction or other methods.

In subsequent step S83, the filling film 500 is formed and flattened (see FIG. 23B). Specifically, the filling film 500 is formed by PE-CVD, and then the filling film 500 is flattened by grinding and polishing using a grinder, a CMP device, or the like.

In subsequent step S84, the first through holes TH1 are formed (see FIG. 23C). Specifically, the filling film 500 and the insulation film 100b1 of the first wiring layer 100b are opened by photolithography and plasma etching to form the first through holes TH1. As a result, the internal wires 100b2 of the first wiring layer 100b are exposed through the first through holes TH1.

In subsequent step S85, the first wires are formed (see FIG. 24A). Specifically, the first wires each including the first through electrode 400a1 and the horizontal wire 400b1 are formed by what is generally called a semi-additive process. First, a Ti film is formed as a barrier metal film by PE-PVD, and then a Cu film is formed as a seed metal film on this Ti film to form the metal film MF. Subsequently, the resist pattern R covering portions where the first wires are not provided is formed by photolithography. Thereafter, electric field plating is carried out with use of the resist pattern R as a mask, to form the metal plating MP1 (e.g., Cu plating). Then, the resist is removed, and the metal film MF covering the portions where the first wires are not provided is removed by wet etching. As a result, the first wires including the metal plating MP1 are formed.

In subsequent step S86, the protection film 550 as a first insulation film is formed and flattened (see FIG. 24B). Specifically, the insulation film 300 is formed by PE-CVD (Plasma-Enhanced chemical vapor deposition) or ALD (Atomic Layer Deposition), and flattened by grinding and polishing with use of a grinder, a CMP device, or the like, for example.

In subsequent step S87, the protection film 550 as the first insulation film is joined to the support substrate 560 (see FIG. 31A). Specifically, the support substrate 560 as a semiconductor substrate on a surface of which an oxide film is slightly formed is directly joined to the protection film 550. The support substrate 560 is affixed in a state of a wafer.

In subsequent step S88, the thickness of the first element chip 100 is reduced (see FIG. 31B). Specifically, the rear surface (upper surface) of the first semiconductor substrate 100a of the first element chip 100 is ground and polished using a grinder, a CMP device, or the like, for example, to reduce the thickness of the first element chip 100 to 10 µm.

In subsequent step S89, an anti-reflection film, the color filters 910, and the micro-lenses 920 are formed (see FIG. 31C).

In subsequent step S90, the transparent substrate 940 is joined to the first element chip 100 via the adhesive 930 (see FIG. 32A).

In subsequent step S91, the thickness of the support substrate 560 is reduced (see FIG. 32B). Specifically, the thickness of the support substrate 560 is reduced to approximately 100 µm by a grinder, a CMP device, or the like, for example.

In subsequent step S92, the second through holes TH2 are formed in the support substrate 560 (see FIG. 33A). Specifically, the second through holes TH2 are formed in the support substrate 560 by lithography or plasma etching.

In subsequent step S93, the insulation film 570 is formed as a second insulation film (see FIG. 33B). Specifically, the insulation film 570 is formed by PE-CVD or ALD.

In subsequent step S94, first contact holes are formed. Specifically, the insulation film 570 and the protection film 550 on bottom portions of the second through holes TH2 are opened by dry etching to form the first contact holes. As a result, some parts of the first wires (metal plating MP1) are exposed through the first contact holes.

In subsequent step S95, the second wires are formed (see FIG. 34A). Specifically, the metal plating MP2 which has the second through electrodes 400c1 within the first contact holes and the second through holes TH2 and has rear surface wires on the rear surface of the support substrate 560 around the second through holes TH2 to constitute the second wires is formed by what is generally called a semi-additive process.

In subsequent step S96, the protection film 600 is formed (see FIG. 34B). Specifically, a film including a photosensitive resin material is formed as the protection film 600, for example.

In subsequent step S97, the second contact holes CH2 are formed (see FIG. 35A). Specifically, the protection film 600 is opened by photolithography and dry etching to form the second contact holes CH2. As a result, some parts (rear surface wires) of the second wires (metal plating MP2) are exposed through the second contact holes CH2.

In final step S98, the external connection terminals 700 are formed (see FIG. 35B). Specifically, the external connection terminals 700 (e.g., solder balls) are formed by ball mounting at the second contact holes CH2 in such a manner as to be connectable with some parts (rear surface wires) of the second wires (metal plating MP2).

### <<Advantageous effects of semiconductor device>>

According to the semiconductor device 90, junction between the chips and formation of the wires, the filling film, and the protection film are achievable before formation of the color filters and the on-chip lenses requiring a limited processing temperature. Accordingly, a higher quality and more reliable semiconductor device is providable. Moreover, in a case where the first element chip 100 is a pixel chip, the thickness of the first element chip 100 is required to be reduced to a thickness of 30 µm or smaller, for example. In this case, each of the second element chips 200 needs to have a larger thickness to obtain sufficient mechanical strength. Hence, the layout of the external connection wires of the present technology is extremely advantageous.

Further, the semiconductor device 90 having the support substrate 560 is allowed to reduce each thickness of the second element chips 200. Accordingly, the vias 400a1 each having a small diameter can be formed relatively easily.

The support substrate 560 may have a semiconductor substrate and/or a wiring layer. In this case, elements may be provided on the semiconductor substrate. Elements not requiring high integration are suited for these elements.

### <10. Semiconductor device according to example 10 of one embodiment of present technology>

### <<Configuration of semiconductor device>>

FIG. 36 is a cross-sectional diagram of a semiconductor device 110 according to example 10 of one embodiment of the present technology. As depicted in FIG. 36, the semiconductor device 110 according to example 10 includes the support substrate 560 joined to the second element chips 200 via the filling film 500 constituting an insulation layer. The external connection terminals 700 are provided near the support substrate 560 on the side opposite to the filling film 500. Each of wires 400H has a through electrode penetrating the filling film 500 and the support substrate 560. The filling film 500 is flattened and joined to the support substrate 560.

The support substrate 560 in one example has a size substantially identical to the size of the first element chip 100.

The filling film 500 is provided near the side surface of each of the second element chips 200 and near the second element chips 200 on the side opposite to the first element chip 100. The insulation film 570 is provided between each of the wires 400H and the area of the filling film 500 and the support substrate 560, and on the surface of the support substrate 560 on the side opposite to the first element chip 100. The insulation film 570 is covered with the protection film 600. Each of the through electrodes of the wires 400H penetrates the filling film 500 and the support substrate 560 near the side surface of the second element chip 200 in the lamination direction. One end of the through electrode is connected to the internal wire 100b2 of the first wiring layer 100b, and the other end is located in the vicinity of the protection film 600. Each of the wires 400H further includes a rear surface wire connected to the other end of the through electrode in the vicinity of the protection film 600. This rear surface wire is connected to the corresponding external connection terminal 700 within the protection film 600.

According to the semiconductor device 110, an etching stop layer 950 is provided at least at portions included in the first wiring layer 100b but not joined to the second wiring layer 200b. The etching stop layer 950 in one example here is provided along the first and second element chips 100 and 200.

For example, an inorganic film including SiO₂, SiON, SiN, SiOC, SiCN, or the like, or an organic film including resin containing silicone, polyimide, acryl, epoxy, or the like as a frame is available as the etching stop layer 950. It is preferable that the etching stop layer 950 include a material having dry etching selectivity for the filling film 500. For example, if the filling film 500 includes SiO₂, the etching stop layer preferably includes SiN.

### <<Manufacturing method of semiconductor device>>

A manufacturing method of the semiconductor device 110 will hereinafter be described with reference to a flowchart in FIG. 37, FIG. 38A to FIG. 40C, and the like.

In first step S101, the first element chip 100 and a plurality of second element chips 200 are prepared (see FIGS. 4A and 4B). Specifically, for forming the first element chip 100, elements are formed on the first semiconductor substrate 100a by photolithography, and the first wiring layer 100b is formed on the first semiconductor substrate 100a. For forming the plurality of second element chips 200, elements are formed for each chip on a wafer constituting the second semiconductor substrates 200a by photolithography, and a wiring film constituting the second wiring layer 200b is formed on the wafer. Thereafter, the wafer is divided for each chip by dicing.

In subsequent step S102, the first element chip 100 and the plurality of second element chips 200 are joined to each other (see FIG. 23A). Specifically, the first wiring layer 100b of the first element chip 100 and the second wiring layers 200b of the second element chips 200 are directly joined face-to-face with each other by metal junction or other methods.

In subsequent step S103, the etching stop layer 950 (e.g., SiN) constituting a first insulation film is formed (see FIG. 38A).

In subsequent step S104, the filling film 500 is formed and flattened (see FIG. 38B). Specifically, the filling film 500 is formed by PE-CVD, and then the filling film 500 is flattened by grinding and polishing using a grinder, a CMP device, or the like.

In subsequent step S105, the filling film 500 and the support substrate 560 are joined to each other (see FIG. 38C). Specifically, the support substrate 560 as a semiconductor substrate on a surface of which an oxide film is slightly formed is directly joined to the filling film 500. The support substrate 560 is affixed in a state of a wafer. At this time, the thickness of the first semiconductor substrate 100a of the first element chip 100 may be reduced by grinding and polishing as necessary.

In subsequent step S106, through holes TH are formed in the support substrate 560 and the filling film 500 (see FIG. 38D). Specifically, the through holes TH are formed in the support substrate 560 by lithography or plasma etching. In this step, the etching stop layer 950 is capable of stopping this etching.

In subsequent step S107, the insulation film 570 is formed as a second insulation film (see FIG. 39A). Specifically, the insulation film 570 is formed on the entire surface by PE-CVD or ALD.

In subsequent step S108, the first contact holes CH1 are formed (see FIG. 39B). Specifically, the insulation film 570, the etching stop layer 950, and the insulation film 100b1 of the first wiring layer 100b are opened by plasma etching to form the first contact holes CH1. As a result, the internal wires 100b2 of the first wiring layer 100b are exposed through the through holes TH and the first contact holes CH1.

In subsequent step S109, the wires 400H are formed (see FIG. 39C). Specifically, the wires 400H each including the through electrode and the rear surface wire are formed by what is generally called a semi-additive process. First, a Ti film is formed as a barrier metal film by PE-PVD, and then a Cu film is formed as a seed metal film on this Ti film to form the metal film MF. Subsequently, the resist pattern R covering portions where the wires 400H are not provided is formed by photolithography. Thereafter, electric field plating is carried out with use of the resist pattern R as a mask, to form metal plating MP (e.g., Cu plating). Then, the resist is removed, and the metal film MF covering the portions where the wires 400H are not provided is removed by wet etching. As a result, the wires 400H including the metal plating MP are formed.

In subsequent step S110, the protection film 600 is formed (see FIG. 40A). Specifically, a film including a photosensitive resin material is formed as the protection film 600, for example.

In subsequent step Sill, the second contact holes CH2 are formed (see FIG. 40B). Specifically, the protection film 600 is opened by photolithography and dry etching to form the second contact holes CH2. As a result, some parts (rear surface wires) of the wires 400H (metal plating MP) are exposed through the second contact holes CH2.

In final step S112, the external connection terminals 700 are formed (see FIG. 40C). Specifically, the external connection terminals 700 (e.g., solder balls) are formed by ball mounting at the second contact holes CH2 in such a manner as to be connectable with the some parts (rear surface wires) of the wires 400H (metal plating MP) .

### <<Advantageous effects of semiconductor device>>

The semiconductor device 110 provided here achieves high integration by a relatively simple configuration.

The manufacturing method of the semiconductor device 110 includes a step of joining the first wiring layer 100b of a first lamination stack that includes the first semiconductor substrate 100a and the first wiring layer 100b laminated together and the second wiring layer 200b of a second lamination stack that is smaller than the first lamination stack and includes the second semiconductor substrate 200a and the second wiring layer 200b laminated together, in such a manner that the first wiring layer 100b and the second wiring layer 200b face each other, a step of forming the etching stop layer 950 from the second lamination stack on the side opposite to the first lamination stack, a step of forming the filling film 500 from the edging stop layer 950 on the side opposite to the first lamination stack, a step of flattening the filling film 500, a step of joining the support substrate 560 to the filling film 500, and a step of forming a through electrode that penetrates the support substrate 560, the filling film 500 around the second lamination stack, and the etching stop layer 950.

### <11. Semiconductor device according to example 11 of one embodiment of present technology>

### <<Configuration of semiconductor device>>

FIG. 41 is a cross-sectional diagram of a semiconductor device 111 according to example 11 of one embodiment of the present technology. As depicted in FIG. 41, the semiconductor device 111 according to example 11 has a configuration substantially similar to that of the semiconductor device 10 according to example 10 except that each of pixels in a pixel region of the pixel chip constituting the first element chip 100 has the color filter 910 and the micro-lens 920 (on-chip lens). The pixel region may include an anti-reflection film. The first semiconductor device 100a has a reduced thickness approximately in a range of 3 to 30 µm.

The semiconductor device 111 further includes the transparent substrate 940 joined via the adhesive layer 930 to a surface of the pixel chip 100 near a plurality of micro-lenses 920. The adhesive layer 930 may be provided only on a region around the pixel region rather than on the entire surface.

### <<Manufacturing method of semiconductor device>>

A manufacturing method of the semiconductor device 110 will hereinafter be described with reference to a flowchart illustrated in FIGS. 42 and 43, FIG. 44A to FIG. 48B, and the like.

In first step S121, the first element chip 100 and a plurality of second element chips 200 are prepared (see FIGS. 4A and 4B). Specifically, for forming the first element chip 100, elements are formed on the first semiconductor substrate 100a by photolithography, and the first wiring layer 100b is formed on the first semiconductor substrate 100a. For forming the plurality of second element chips 200, elements are formed for each chip on a wafer constituting the second semiconductor substrates 200a by photolithography, and a wiring film constituting the second wiring layer 200b is formed on the wafer. Thereafter, the wafer is divided for each chip by dicing.

In subsequent step S122, the first element chip 100 and the plurality of second element chips 200 are joined to each other (see FIG. 23A). Specifically, the first wiring layer 100b of the first element chip 100 and the second wiring layers 200b of the second element chips 200 are directly joined face-to-face with each other by metal junction or other methods.

In subsequent step S123, the etching stop layer 950 (e.g., SiN) constituting a first insulation film is formed (see FIG. 38A).

In subsequent step S124, the filling film 500 is formed and flattened (see FIG. 38B). Specifically, the filling film 500 is formed by PE-CVD, and then the filling film 500 is flattened by grinding and polishing using a grinder, a CMP device, or the like.

In subsequent step S125, the filling film 500 and the support substrate 560 are joined to each other (see FIG. 38C). Specifically, the support substrate 560 as a semiconductor substrate on a surface of which an oxide film is slightly formed is directly joined to the protection film 550. The support substrate 560 is affixed in a state of a wafer.

In subsequent step S126, the thickness of the first element chip 100 is reduced (see FIG. 44A). Specifically, the rear surface (upper surface) of the first semiconductor substrate 100a of the first element chip 100 is ground and polished using a grinder, a CMP device, or the like, for example, to reduce the thickness of the first element chip 100 to 10 µm.

In subsequent step S127, an anti-reflection film, the color filters 910, and the micro-lenses 920 are formed (see FIG. 44B).

In subsequent step S128, the transparent substrate 940 is joined to the first element chip 100 via the adhesive 930 (see FIG. 45A).

In subsequent step S129, the thickness of the support substrate 560 is reduced. Specifically, the thickness of the support substrate 560 is reduced to approximately 100 µm by a grinder, a CMP device, or the like, for example.

In subsequent step S130, the through holes TH are formed in the support substrate 560 and the filling film 500 (see FIG. 45B). Specifically, the through holes TH are formed in the support substrate 560 by lithography and plasma etching. In this step, the etching stop layer 950 can stop this etching.

In subsequent step S131, the insulation film 570 is formed as a second insulation film (see FIG. 46A). Specifically, the insulation film 570 is formed on the entire surface by PE-CVD or ALD.

In subsequent step S132, the first contact holes CH1 are formed (see FIG. 46B). Specifically, the insulation film 570, the etching stop layer 950, and the insulation film 100b1 of the first wiring layer 100b are opened by plasma etching to form the first contact holes CH1. As a result, the internal wires 100b2 of the first wiring layer 100b are exposed through the through holes TH and the first contact holes CH1.

In subsequent step S133, the wires 400H are formed (see FIG. 47A). Specifically, the wires 400H each including the through electrode and the rear surface wire are formed by what is generally called a semi-additive process. First, a Ti film is formed as a barrier metal film by PE-PVD, and then a Cu film is formed as a seed metal film on this Ti film to form the metal film MF. Subsequently, the resist pattern R covering portions where the wires 400H are not provided is formed by photolithography. Thereafter, electric field plating is carried out with use of the resist pattern R as a mask, to form the metal plating MP (e.g., Cu plating). Then, the resist is removed, and the metal film MF covering the portions where the wires 400H are not provided is removed by wet etching. As a result, the wires 400H including the metal plating MP are formed.

In subsequent step S134, the protection film 600 is formed (see FIG. 47B). Specifically, a film including a photosensitive resin material is formed as the protection film 600, for example.

In subsequent step S135, the second contact holes CH2 are formed (see FIG. 48A). Specifically, the protection film 600 is opened by photolithography and dry etching to form the second contact holes CH2. As a result, some parts (rear surface wires) of the wires 400H (metal plating MP) are exposed through the second contact holes CH2.

In final step S136, the external connection terminals 700 are formed (see FIG. 48B). Specifically, the external connection terminals 700 (e.g., solder balls) are formed by ball mounting at the second contact holes CH2 in such a manner as to be connectable with some parts (rear surface wires) of the wires 400H (metal plating MP).

### <<Advantageous effects of semiconductor device>>

According to the semiconductor device 111, junction between the chips and formation of the insulation film, the wires, and the filling film are achievable before formation of the color filters and the on-chip lenses requiring a limited processing temperature. Accordingly, a higher quality and more reliable semiconductor device is providable. Moreover, in a case where the first element chip 100 is a pixel chip, the first element chip 100 is required to have a thickness of 30 µm or smaller, for example. In this case, each of the second element chips 200 has a larger thickness to obtain sufficient mechanical strength. Hence, the layout of the external connection wires of the present technology is extremely advantageous in view of this point.

### <12. Modifications of present technology>

The configurations of the semiconductor devices according to the respective examples described above may be modified in appropriate manners.

For example, the configurations of the semiconductor devices according to the respective examples described above may be combined within a range of no technical inconsistency.

For example, a through electrode which penetrates the at least one chip including the second element chip may be provided in addition to the external connection wire at least a part of which is provided around this chip.

For example, a wire which includes the wire portion disposed along at least one chip including the second element chip and a through electrode penetrating the support substrate disposed near this chip on the side opposite to the first element chip may be provided.

For example, the at least one chip including the second element chip may be a single second element chip.

For example, at least one first element chip may include a plurality of first element chips.

For example, each of the semiconductor devices according to examples 6, 9, and 11 may not have at least any one of the anti-reflection film, color filters, and micro-lenses (on-chip lenses). For example, in a case where these semiconductor devices are used for a purpose of forming black-and-white images, the color filters may be eliminated. For example, in a case where these semiconductor devices are used for a purpose of such sensing as distance measurement, at least either the color filters or the micro-lenses may be eliminated.

While described in each of the examples is such a case where the semiconductor device according to the present technology constitutes a solid-state imaging device, the semiconductor device according to the present technology may constitute a part of a solid-state imaging device (e.g., processing unit). For example, the semiconductor device according to the present technology may designate any one of a memory chip, a logic chip, an analog chip, an interface chip, and an AI chip as each of the first element chip and the second element chip.

The numerical values, materials, shapes, sizes, and the like presented in the above description of the respective examples are given not as limiting factors, but as a mere example.

### <13. Use example of solid-state imaging device to which present technology is applied>

FIG. 49 is a diagram depicting use examples of a case where the semiconductor device according to the present technology (e.g., each of the semiconductor devices according to the respective examples) constitutes a solid-state imaging device (image sensor).

For example, each of the examples described above is available as an imaging sensor in various cases associated with sensing of light such as visible light, infrared light, ultraviolet light, and X-rays as will be described below. Specifically, as depicted in FIG. 49, each of the examples is available as devices used in an appreciation field for capturing images provided for appreciation, a transportation field, a home appliance field, a medical treatment and healthcare field, a security field, a beauty field, a sport field, and an agricultural field, for example.

Specifically, in the appreciation field, the semiconductor device according to the present technology is available as a device for capturing images provided for appreciation, such as a digital camera, a smartphone, and a cellular phone equipped with a camera function, for example.

In the transportation field, the semiconductor device according to the present technology is available as a device provided for transportation, such as an in-vehicle sensor for capturing images before and behind, surroundings, and an interior of a car, a monitoring camera for monitoring running vehicles and roads, and a distance measuring sensor for measuring distances between vehicles and the like, each for purposes of safety driving such as an automatic stop, recognition of a state of a driver, and others, for example.

In the home appliance field, the semiconductor device according to the present technology is available as a device provided for home appliances, such as a television set, a refrigerator, and an air conditioner, for capturing an image of a gesture of a user and performing a device operation according to the gesture, for example.

In the medical treatment and healthcare field, the semiconductor device according to the present technology is available as a device provided for medical treatments and healthcare, such as an endoscope and a device for performing angiogram according to received infrared light, for example.

In the security field, the semiconductor device according to the present technology is available as a device provided for security, such as a monitoring camera for crime prevention and a camera for person authentication, for example.

In the beauty field, the semiconductor device according to the present technology is available as a device provided for beauty, such as a skin measuring device for capturing an image of skin and a microscope for capturing an image of scalp, for example.

In the sport field, the semiconductor device according to the present technology is available as a device provided for sports, such as an action camera for sports and a wearable camera, for example.

In the agricultural field, the semiconductor device according to the present technology is available as a device provided for agriculture, such as a camera for monitoring states of fields and crops, for example.

Next, a specific use example of the semiconductor device according to the present technology (e.g., the semiconductor devices according to the respective examples) will be described. For example, each of the semiconductor devices according to the respective examples described above is applicable to a solid-state imaging device 501 included in any type of electronic apparatus having an imaging function, such as a camera system constituting a digital still camera, a video camera, or the like and a cellular phone having an imaging function. FIG. 50 depicts a schematic configuration of an electronic apparatus 510 (camera) as one example of the electronic apparatus. The electronic apparatus 510 here is a video camera capable of capturing still images or moving images, for example, and includes the solid-state imaging device 501, an optical system (optical lens) 502, a shutter device 503, a drive unit 504 for driving the solid-state imaging device 501 and the shutter device 503, and a signal processing unit 505.

The optical system 502 introduces image light (incident light) from a subject to a pixel region of the solid-state imaging device 501. The optical system 502 may include a plurality of optical lenses. The shutter device 503 controls periods for applying light and shielding light to and from the solid-state imaging device 501. The drive unit 504 controls a transfer operation of the solid-state imaging device 501 and a shutter operation of the shutter device 503. The signal processing unit 505 performs various types of signal processing for signals output from the solid-state imaging device 501. A video signal Dout obtained by signal processing is stored in a storage medium such as a memory, or output to a monitor or the like.

### <14. Different use example of solid-state imaging device to which present technology is applied>

The semiconductor device according to the present technology (e.g., the semiconductor devices according to the respective examples) is applicable to a different type of electronic apparatus which detects light, such as a TOF (Time Of Flight) sensor. Examples of the TOF sensor to which the semiconductor device according to the present technology is applicable include a distance image sensor using a direct TOF measuring method and a distance image sensor using an indirect TOF measuring method. According to the distance image sensor using the direct TOF measuring method, photon coming timing is calculated by a direct time domain for each pixel. Accordingly, a light pulse having a short pulse width is transmitted, and an electric pulse is generated by a fast-response receiver. The present disclosure is applicable to the receiver used for this purpose. In contrast, according to the indirect TOF method, light flight time is measured using a semiconductor element structure where detection and an accumulation quantity of carriers generated by light are variable according to light coming timing. The present disclosure is also applicable to such a semiconductor structure. In the case of application to the TOF sensor, the color filter array and the micro-lens array depicted in FIG. 16 or other figures are not necessarily required. These arrays may be eliminated.

### <15. Example of application to mobile body>

The technology according to the present disclosure (present technology) is applicable to various products. For example, the technology according to the present disclosure may be implemented as a device mounted on any type of mobile bodies such as a car, an electric car, a hybrid electric car, a motorcycle, a bicycle, a personal mobility, an airplane, a drone, a vessel, and a robot.

FIG. 51 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 51, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 51, an audio speaker 12061, a display section 12062, and an instrument panel 12063 are illustrated as the output device. The display section 12062 may, for example, include at least one of an on-board display and a head-up display.

FIG. 52 is a diagram depicting an example of the installation position of the imaging section 12031.

In FIG. 52, the vehicle 12100 includes, as the imaging section 12031, imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The image of the front obtained by the imaging section 12101 or 12105 is used mainly to detect a preceding vehicle, a pedestrian, an obstacle, a signal, a traffic sign, a lane, or the like.

Incidentally, FIG. 52 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

One example of the vehicle control system to which the technology according to the present disclosure (present technology) is applicable has been described above. For example, the technology according to the present disclosure is applicable to the imaging section 12031 and the like in the configuration described above. Specifically, the solid-state imaging device 111 of the present disclosure is applicable to the imaging section 12031. The imaging section 12031 to which the technology according to the present disclosure is applied can improve yields and reduce costs associated with manufacture.

### <16. Example of application to endoscopic surgery system>

The present technology is applicable to various products. For example, the technology according to the present disclosure (present technology) is applicable to an endoscopic surgery system.

FIG. 53 is a view depicting an example of a schematic configuration of an endoscopic surgery system to which the technology according to an embodiment of the present disclosure (present technology) can be applied.

In FIG. 53, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

FIG. 54 is a block diagram depicting an example of a functional configuration of the camera head 11102 and the CCU 11201 depicted in FIG. 53.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The image pickup unit 11402 includes image pickup elements. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

One example of the endoscopic surgery system to which the technology according to the present disclosure is applicable has been described above. The technology according to the present disclosure is applicable to the endoscope 11100, the camera head 11102 (the image pickup unit 11402 of the camera head 11102), and the like in the configuration described above. Specifically, the solid-state imaging device 111 of the present disclosure is applicable to the image pickup unit 10402. The endoscope 11100, the camera head 11102 (the image pickup unit 11402 of the camera head 11102), and the like to which the technology according to the present disclosure is applied can improve yields and reduce costs associated with manufacture.

While the endoscopic surgery system has been described here by way of example, the technology according to the present disclosure is applicable to a microscopic surgery system or the like, for example.

Further, the present technology can also take the following configurations.
(1) A semiconductor device including:
   at least one first element chip; and
   at least one chip laminated with the first element chip and smaller than the first element chip,
   in which the at least one chip includes at least one second element chip,
   the first element chip has a laminated structure where a first semiconductor substrate and a first wiring layer are laminated,
   the second element chip has a laminated structure where a second semiconductor substrate and a second wiring layer are laminated,
   the first wiring layer and the second wiring layer are joined face-to-face with each other,
   the semiconductor device further includes
      an external connection terminal disposed at a position farther from the first element chip in a lamination direction than a rear surface of the chip, the rear surface being a surface on the side opposite to the first element chip, and
      a wire that has at least a part disposed around the chip and electrically connects the first wiring layer and the external connection terminal.
(2) The semiconductor device according to (1), in which the wire has at least one vertical wire that extends in the lamination direction.
(3) The semiconductor device according to (2), in which the wire has at least one horizontal wire that extends in an in-plane direction and that is connected to the vertical wire.
(4) The semiconductor device according to (3), in which the at least one vertical wire includes
   at least one first vertical wire that extends from the horizontal wire toward the first semiconductor substrate, and
   at least one second vertical wire that extends from the horizontal wire toward the side opposite to the first semiconductor substrate.
(5) The semiconductor device according to any one of (1) through (4), in which the wire is provided at least on a side surface of the chip via an insulation film.
(6) The semiconductor device according to any one of (1) through (5), in which the wire is configured such that one end is electrically connected to the first wiring layer, and that the other end is connected to the external connection terminal at a position farther from the first element chip in the lamination direction than the rear surface.
(7) The semiconductor device according to any one of (1) through (6), further including:
   a filling film provided at least near a side surface of the chip in an area of the side surface and the rear surface of the chip.
(8) The semiconductor device according to (7), in which the filling film is flattened.
(9) The semiconductor device according to (7) or (8), in which the filling film is disposed near the chip on a side opposite to the first element chip and so provided as to cover a part of the external connection terminal.
(10) The semiconductor device according to any one of (7) through (9), further including:
   an insulation layer that covers the filling film and a part of the external connection terminal and exposes a remaining part of the external connection terminal.
(11) The semiconductor device according to any one of (1) through (10), in which the chip is shaped to have a width that decreases with farness from the first element chip.
(12) The semiconductor device according to any one of (1) through (11), in which the chip has a vertical cross section that has a substantially tapered shape whose width decreases with farness from the first element chip.
(13) The semiconductor device according to any one of (1) through (12), in which the chip has a rounded corner.
(14) The semiconductor device according to any one of (1) through (13), in which the at least one chip includes at least one dummy chip.
(15) The semiconductor device according to any one of (1) through (14), in which the external connection terminal has at least a part not overlapping with the chip in a planar view.
(16) The semiconductor device according to (5), in which
   the insulation film is provided only near the side surface, and
   a protection film disposed on a surface of the chip which is a surface opposite to the first element chip is further provided.
(17) The semiconductor device according to (16), further including:
   a different protection film that covers the protection film and a part of the external connection terminal and exposes a remaining part of the external connection terminal.
(18) The semiconductor device according to any one of (1) through (17), in which the first element chip includes a pixel chip that includes a pixel region in the first semiconductor substrate.
(19) The semiconductor device according to (18), in which the first element chip includes a transparent substrate joined to the first semiconductor substrate via an adhesive layer.
(20) The semiconductor device according to any one of (1) through (19), further including:
   a support substrate joined to the chip via an insulation layer, in which
   the external connection terminal is provided near the support substrate on a side opposite to the insulation layer, and
   the wire has a through electrode that penetrates the insulation layer and/or the support substrate.
(21) The semiconductor device according to (20), in which the support substrate has a size substantially identical to a size of the first element chip.
(22) The semiconductor device according to (20) or (21), in which
   the insulation layer is provided near the side surface of the chip and a side of the chip opposite to the first element chip, and
   the wire includes
      a first through electrode that penetrates the insulation layer near the side surface of the chip,
      a second through electrode that penetrates the support substrate, and
      a horizontal wire that is disposed within the insulation layer and electrically connects the first and second through electrodes.
(23) The semiconductor device according to any one of (20) through (22), in which the support substrate includes a semiconductor substrate.
(24) The semiconductor device according to (23), in which the support substrate includes an element.
(25) The semiconductor device according to (20) through (24), in which
   the insulation layer is provided near the side surface of the chip and a side of the chip opposite to the first element chip, and
   the through electrode penetrates the insulation layer near the side surface of the chip and the support substrate.
(26) The semiconductor device according to any one of (20) through (25), in which an etching stop layer is provided at least on a portion included in the first wiring layer but not joined to the second wiring layer.
(27) The semiconductor device according to any one of (20) through (26), in which the first element chip includes a pixel chip that includes a pixel region in the first semiconductor substrate.
(28) The semiconductor device according to (27), in which the first element chip includes a transparent substrate joined to the first semiconductor substrate via an adhesive layer.
(29) An apparatus including:
   the semiconductor device according to any one of (1) through (28) .
(30) A manufacturing method of a semiconductor device, the method including:
   a step of joining a first wiring layer of a first lamination stack that includes a first semiconductor substrate and the first wiring layer laminated together and a second wiring layer of at least one second lamination stack that is smaller than the first lamination stack and includes a second semiconductor substrate and the second wiring layer laminated together, in such a manner that the first wiring layer and the second wiring layer face each other;
   a step of forming an insulation film from the second lamination stack on a side opposite to the first lamination stack;
   a step of etching the insulation film and the first wiring layer around the second lamination stack to expose an in-layer wire of the first wiring layer; and
   a step of forming a wire that is disposed at least near a side surface of the second lamination stack and is connected to the in-layer wire.
(31) The manufacturing method of a semiconductor device according to (30), the method further including:
   a step of forming a filling film from the second lamination stack on the side opposite to the first lamination stack; and
   a step of polishing and flattening at least the filling film.
(32) The manufacturing method of a semiconductor device according to (31), in which
   the at least one second lamination stack includes a plurality of second lamination stacks having different thicknesses, and
   the step of flattening also polishes and flattens the plurality of second lamination stacks.
(33) The manufacturing method of a semiconductor device according to (31) or (32), further including:
   a step of joining a support substrate to the filling film after the step of flattening.
(34) The manufacturing method of a semiconductor device according to (33), in which
   the first lamination stack constitutes a pixel chip, and
   the method further includes a step of forming at least any one of an anti-reflection film, a color filter, and an on-chip lens near the first semiconductor substrate on the side opposite to the first wiring layer after the step of joining the support substrate to the filling film.
(35) A manufacturing method of a semiconductor device, the method including:
   a step of joining a first wiring layer of a first lamination stack that includes a first semiconductor substrate and the first wiring layer laminated together and a second wiring layer of a second lamination stack that is smaller than the first lamination stack and includes a second semiconductor substrate and the second wiring layer laminated together, in such a manner that the first wiring layer and the second wiring layer face each other;
   a step of forming a filling film from the second lamination stack on a side opposite to the first lamination stack;
   a step of flattening the filling film;
   a step of etching the filling film and the first wiring layer around the second lamination stack to form a via that has one end connected to an in-layer wire of the first wiring layer;
   a step of forming a horizontal wire that is disposed on a surface of the filling film on a side opposite to the second lamination stack and is electrically connected to the other end of the via;
   a step of covering the horizontal wire with a protection film;
   a step of arranging a support substrate near the protection film on the side opposite to the first lamination stack; and
   a step of forming a through electrode disposed on the support substrate and connected to the horizontal wire.
(36) The manufacturing method of a semiconductor device according to (35), in which
   the support substrate includes a semiconductor substrate, and
   the method further includes a step of forming a wiring layer on the protection film between the step of covering with the protection film and the step of arranging the support substrate.
(37) The manufacturing method of a semiconductor device according to (35), in which
   the first lamination stack constitutes a pixel chip, and
   the method further includes a step of forming at least any one of an anti-reflection film, a color filter, and an on-chip lens near the first semiconductor substrate on a side opposite to the first wiring layer after the step of joining the support substrate.
(38) A manufacturing method of a semiconductor device, the method including:
   a step of joining a first wiring layer of a first lamination stack that includes a first semiconductor substrate and the first wiring layer laminated together and a second wiring layer of a second lamination stack that is smaller than the first lamination stack and includes a second semiconductor substrate and the second wiring layer laminated together, in such a manner that the first wiring layer and the second wiring layer face each other;
   a step of forming an etching stop layer from the second lamination stack on a side opposite to the first lamination stack;
   a step of forming a filling film from the edging stop layer on the side opposite to the first lamination stack;
   a step of flattening the filling film;
   a step of joining a support substrate to the filling film; and
   a step of forming a through electrode that penetrates the support substrate, the filling film around the second lamination stack, and the etching stop layer.
(39) The manufacturing method of a semiconductor device according to (38), in which
   the first lamination stack constitutes a pixel chip, and
   the method further includes a step of forming at least any one of an anti-reflection film, a color filter, and an on-chip lens near the first semiconductor substrate on a side opposite to the first wiring layer after the step of joining the support substrate to the filling film.
(40) The semiconductor device according to (1) through (28), in which the wire does not penetrate the chip.

### [Reference Signs List]

10, 20, 30, 40, 50, 60, 70, 80, 90, 110, 111: Semiconductor device
100: First element chip
100a: First semiconductor substrate
100b: First wiring layer
200, 200B: Second element chip
200C: Dummy chip
200a: Second semiconductor device
200b: Second wiring layer
300: Insulation film
400, 400D, 400E, 400G, 400H: Wire
400a1: First through electrode (through electrode)
400b1: Horizontal wire
400c1, 400d1: Second through electrode (through electrode)
500: Filling film
510: Electronic apparatus (apparatus)
550: Protection film
560: Support substrate
570: Insulation film
600: Protection film
700: External connection terminal
910: Color filter
920: On-chip lens
930: Adhesive layer
940: Transparent substrate

## Claims

1. A semiconductor device comprising:
at least one first element chip; and
at least one chip laminated with the first element chip and smaller than the first element chip,
wherein the at least one chip includes at least one second element chip,
the first element chip has a laminated structure where a first semiconductor substrate and a first wiring layer are laminated,
the second element chip has a laminated structure where a second semiconductor substrate and a second wiring layer are laminated,
the first wiring layer and the second wiring layer are joined face-to-face with each other,
the semiconductor device further includes
an external connection terminal disposed at a position farther from the first element chip in a lamination direction than a rear surface of the chip, the rear surface being a surface on the side opposite to the first element chip, and
a wire that has at least a part disposed around the chip and electrically connects the first wiring layer and the external connection terminal.

2. The semiconductor device according to claim 1, wherein the wire has at least one vertical wire that extends in the lamination direction.

3. The semiconductor device according to claim 2, wherein the wire has at least one horizontal wire that extends in an in-plane direction and that is connected to the vertical wire.

4. The semiconductor device according to claim 3, wherein the at least one vertical wire includes
at least one first vertical wire that extends from the horizontal wire toward the first semiconductor substrate, and
at least one second vertical wire that extends from the horizontal wire toward the side opposite to the first semiconductor substrate.

5. The semiconductor device according to claim 1, wherein the wire is provided at least on a side surface of the chip via an insulation film.

6. The semiconductor device according to claim 5, wherein the wire is configured such that one end is electrically connected to the first wiring layer, and that the other end is connected to the external connection terminal at a position farther from the first element chip in the lamination direction than the rear surface.

7. The semiconductor device according to claim 1, further comprising:
a filling film provided at least near a side surface of the chip in an area of the side surface and the rear surface of the chip.

8. The semiconductor device according to claim 7, wherein the filling film is flattened.

9. The semiconductor device according to claim 7, wherein the filling film is disposed near the rear surface and so provided as to cover a part of the external connection terminal.

10. The semiconductor device according to claim 7, further comprising:
an insulation layer that covers the filling film and a part of the external connection terminal and exposes a remaining part of the external connection terminal.

11. The semiconductor device according to claim 1, wherein the chip is shaped to have a width that decreases with farness from the first element chip.

12. The semiconductor device according to claim 1, wherein the chip has a vertical cross section that has a substantially tapered shape whose width decreases with farness from the first element chip.

13. The semiconductor device according to claim 1, wherein the chip has a rounded corner.

14. The semiconductor device according to claim 1, wherein the at least one chip includes at least one dummy chip.

15. The semiconductor device according to claim 1, wherein the external connection terminal has at least a part not overlapping with the chip in a planar view.

16. The semiconductor device according to claim 5, wherein
the insulation film is provided only near the side surface, and
a protection film that covers the rear surface of the chip is further provided.

17. The semiconductor device according to claim 16, further comprising:
a different protection film that covers the protection film and a part of the external connection terminal and exposes a remaining part of the external connection terminal.

18. The semiconductor device according to claim 1, wherein the first element chip includes a pixel chip that includes a pixel region in the first semiconductor substrate.

19. The semiconductor device according to claim 18, wherein the first element chip includes a transparent substrate joined to the first semiconductor substrate via an adhesive layer.

20. The semiconductor device according to claim 1, further comprising:
a support substrate joined to the chip via an insulation layer, wherein
the external connection terminal is provided near the support substrate on a side opposite to the insulation layer, and
the wire has a through electrode that penetrates the insulation layer and/or the support substrate.

21. The semiconductor device according to claim 20, wherein the support substrate has a size substantially identical to a size of the first element chip.

22. The semiconductor device according to claim 20, wherein
the insulation layer is provided near the side surface and the rear surface of the chip, and
the wire includes
a first through electrode that penetrates the insulation layer near the side surface of the chip,
a second through electrode that penetrates the support substrate, and
a horizontal wire that is disposed within the insulation layer and electrically connects the first and second through electrodes.

23. The semiconductor device according to claim 20, wherein the support substrate includes a semiconductor substrate.

24. The semiconductor device according to claim 23, wherein the support substrate includes an element.

25. The semiconductor device according to claim 20, wherein
the insulation layer is provided near the side surface and the rear surface of the chip, and
the through electrode penetrates the insulation layer near the side surface of the chip and the support substrate.

26. The semiconductor device according to claim 25, wherein an etching stop layer is provided at least on a portion included in the first wiring layer but not joined to the second wiring layer.

27. The semiconductor device according to claim 20, wherein the first element chip includes a pixel chip that includes a pixel region in the first semiconductor substrate.

28. The semiconductor device according to claim 27, wherein the first element chip includes a transparent substrate joined to the first semiconductor substrate via an adhesive layer.

29. An apparatus comprising:
the semiconductor device according to claim 1.

30. A manufacturing method of a semiconductor device, the method comprising:
a step of joining a first wiring layer of a first lamination stack that includes a first semiconductor substrate and the first wiring layer laminated together and a second wiring layer of at least one second lamination stack that is smaller than the first lamination stack and includes a second semiconductor substrate and the second wiring layer laminated together, in such a manner that the first wiring layer and the second wiring layer face each other;
a step of forming an insulation film from the second lamination stack on a side opposite to the first lamination stack;
a step of etching the insulation film and the first wiring layer around the second lamination stack to expose an in-layer wire of the first wiring layer; and
a step of forming a wire that is disposed at least near a side surface of the second lamination stack and is connected to the in-layer wire.

31. The manufacturing method of a semiconductor device according to claim 30, the method further comprising:
a step of forming a filling film from the second lamination stack on the side opposite to the first lamination stack; and
a step of polishing and flattening at least the filling film.

32. The manufacturing method of a semiconductor device according to claim 31, wherein
the at least one second lamination stack includes a plurality of second lamination stacks having different thicknesses, and
the step of flattening also polishes and flattens the plurality of second lamination stacks.

33. The manufacturing method of a semiconductor device according to claim 31, further comprising:
a step of joining a support substrate to the filling film after the step of flattening.

34. The manufacturing method of a semiconductor device according to claim 33, wherein
the first lamination stack constitutes a pixel chip, and
the method further includes a step of forming at least any one of an anti-reflection film, a color filter, and an on-chip lens near the first semiconductor substrate on the side opposite to the first wiring layer after the step of joining the support substrate to the filling film.

35. A manufacturing method of a semiconductor device, the method comprising:
a step of joining a first wiring layer of a first lamination stack that includes a first semiconductor substrate and the first wiring layer laminated together and a second wiring layer of a second lamination stack that is smaller than the first lamination stack and includes a second semiconductor substrate and the second wiring layer laminated together, in such a manner that the first wiring layer and the second wiring layer face each other;
a step of forming a filling film from the second lamination stack on a side opposite to the first lamination stack;
a step of flattening the filling film;
a step of etching the filling film and the first wiring layer around the second lamination stack to form a via that has one end connected to an in-layer wire of the first wiring layer;
a step of forming a horizontal wire that is disposed on a surface of the filling film on a side opposite to the second lamination stack and is electrically connected to the other end of the via;
a step of covering the horizontal wire with a protection film;
a step of arranging a support substrate near the protection film on the side opposite to the first lamination stack; and
a step of forming a through electrode disposed on the support substrate and connected to the horizontal wire.

36. The manufacturing method of a semiconductor device according to claim 35, wherein
the support substrate includes a semiconductor substrate, and
the method includes a step of forming a wiring layer on the protection film between the step of covering with the protection film and the step of arranging the support substrate.

37. The manufacturing method of a semiconductor device according to claim 35, wherein
the first lamination stack constitutes a pixel chip, and
the method further includes a step of forming at least any one of an anti-reflection film, a color filter, and an on-chip lens near the first semiconductor substrate on a side opposite to the first wiring layer after the step of joining the support substrate.

38. A manufacturing method of a semiconductor device, the method comprising:
a step of joining a first wiring layer of a first lamination stack that includes a first semiconductor substrate and the first wiring layer laminated together and a second wiring layer of a second lamination stack that is smaller than the first lamination stack and includes a second semiconductor substrate and the second wiring layer laminated together, in such a manner that the first wiring layer and the second wiring layer face each other;
a step of forming an etching stop layer from the second lamination stack on a side opposite to the first lamination stack;
a step of forming a filling film from the edging stop layer on the side opposite to the first lamination stack;
a step of flattening the filling film;
a step of joining a support substrate to the filling film; and
a step of forming a through electrode that penetrates the support substrate, the filling film around the second lamination stack, and the etching stop layer.

39. The manufacturing method of a semiconductor device according to claim 38, wherein
the first lamination stack constitutes a pixel chip, and
the method further includes a step of forming at least any one of an anti-reflection film, a color filter, and an on-chip lens near the first semiconductor substrate on a side opposite to the first wiring layer after the step of joining the support substrate to the filling film.
